# EUROPEAN PATENT SPECIFICATION

(11) **EP 2 941 108 B1**
(45) Date of publication and mention of the grant of the patent: **22.11.2017**
(21) Application number: 14166523.2
(22) Date of filing: 30.04.2014
(51) Int. Cl.: H05K 7/20

(54) **Method, controller, and system for controlling cooling system of a computing environment**
Verfahren, Steuerung und System zur Steuerung eines Kühlsystems für eine Computerumgebung
Procédé, contrôleur et système de commande de système de refroidissement d'un environnement informatique

(43) Date of publication of application: 04.11.2015
(73) Proprietor: FUJITSU LIMITED, Kawasaki-shi, Kanagawa 211-8588 (JP)
(72) Inventor: Albornoz, Jose, Iver Heath, SL0 0DL (GB)
(74) Representative: Hutchison, James

(56) References cited:
- EP-A1- 2 098 942
- US-A1- 2004 109 288
- US-B1- 8 397 088

## Description

The present invention lies in the field of controllers for computing environments. In particular, the present invention relates to controllers for modifying cooling system settings based on the distribution of load in a room such as a data centre hall.

Given their enormous electrical power consumption and associated carbon footprint, data centres are natural targets for techniques aimed at improving their energy efficiency and reducing their impact on the environment. This is especially true in light of the explosive growth in the number of data centres and the increasing dependence of our society on the ICT services provided by them. Besides, energy costs are a major fraction of the operating costs of data centres, becoming almost as important as the cost of the facilities and equipment.

The energy required to operate a virtualized data centre can be reduced by appropriately migrating virtual machines (VMs) so that IT loads are concentrated in a particular group of servers located in a given area of the data floor; energy savings can be then be achieved by switching off or hibernating unused servers. Some areas in a data centre are natural targets for this VM migration since they are cooler than others for a variety of reasons (raised floor geometry, spatial distribution of servers and IT loads, positioning of perforated tile and cooling system settings, amongst others): cooling resources could be used more efficiently if VMs are concentrated in these areas, while adjusting or switching off air conditioning units associated to zones with hibernating or powered-down servers. This measure will attain its objective only if there is some degree of airflow segregation between data floor zones, or equivalently, if the settings of the air conditioning system and the spatial distribution of VMs can be adjusted so that the supply of cooling resources is reduced or suppressed in those zones where hibernating/switched-off servers are located, while guaranteeing adequate cooling in those zones where active servers are concentrated. The impact of this strategy is substantial since cooling system consumption represents an important fraction of the total energy consumption in most data centres.

US2004109288 (A1) discloses a data centre having a plurality of racks cooled by activating a cooling device and opening a controllable partition configured to vary a supply of cooling fluid within a zone of the data centre. The zone includes at least one associated rack of the plurality of racks. In addition, the temperature of at least one associated rack is sensed and it is determined whether the sensed temperature is within a predetermined temperature range. Furthermore, the controllable partition is manipulated to vary the supply of the cooling fluid to the zone in response to the sensed temperature being outside the predetermined temperature range.

EP2098942 (A1) discloses a method of operating a data center in which the distribution of processing load takes into account the discrete steps that occur in power consumption by cooling equipment (e.g. an increase in speed of a fan from one preset speed to another preset speed or the starting of an additional air-conditioning unit). For each of a number of cooling regions, data representing expected increases in power consumption resulting from the running of additional software on a processor within that cooling region are stored in persistent storage. On receiving a request from an application for additional resource, a power management component for a cooling region within the data centre looks up the stored data and predicts a temperature rise for the cooling region if the additional resource was to be provided from within the cooling region. If the temperature rise is sufficient to trigger a step change in the power consumption of air-conditioning equipment (including fans and coolers), then an attempt is made to provide the requested resource from a different cooling region.

US8397088 (B1) discloses a system and method of scheduling tasks, comprising receiving activity and performance data from registers or storage locations maintained by hardware and an operating system; storing calibration coefficients associated with the activity and performance data; computing an energy dissipation rate based on at least the activity and performance data; and scheduling tasks under the operating system based on the computed energy dissipation rate.

The present invention is defined by the appended independent claims, to which reference should now be made. Specific embodiments are defined in the dependent claims.

Embodiments of the present invention include a controller for a computing environment, the computing environment including: a plurality of computing entities housed within an enclosure, each computing entity having a predetermined maximum operating temperature, the enclosure comprising a plurality of cooling regions each having a portion of the plurality of computing entities located therein; and a cooling system comprising a plurality of air handling entities, each cooling region being assigned one of the air handling entities, each air handling entity being in fluid communication with the cooling region to which the air handling entity is assigned. The controller itself comprises: a load management module configured to maintain an indication of which of the plurality of cooling regions are in a first state and which of the plurality of cooling regions are in a second state, the first state being handling less than a first predetermined threshold level of computing load and the second state being handling more than a second predetermined threshold level of computing load; a load migration instructing module configured to, when the load management module indicates that one or more cooling regions are in the second state, instruct a migration of load among the cooling regions, the instructed migration causing the level of computing load handled at one of the one or more cooling regions indicated as being in the second state to enter the first state; a temperature monitoring module configured to monitor the operating temperature of each of the computing entities and to indicate whether or not a cooling condition is satisfied, the cooling condition being that the operating temperature of the or each of a predetermined minimum number of computing entities from among the plurality of computing entities is above the respective maximum operating temperature; and a cooling resource management module being configured to perform a cooling resource supply management process. The cooling resource supply management process comprises, following execution of the instructed migration of load among the cooling regions, obtaining, as a first indication, and indication of whether or not the cooling condition is satisfied, and if the first indication is that that the cooling condition is not satisfied, reducing a first cooling resource supply rate, the first cooling resource supply rate being the rate at which cooling resources are delivered to the enclosure by the or each air handling entity assigned to a cooling region in the first state from among the plurality of cooling regions.

The controller observes the spatial distribution of computing load (which may be the spatial Virtual Machine (VM) distribution) and adjusts the supply of cooling resources to different cooling regions/areas/zones in response to the observed spatial distribution. The use of cooling resources in cooling regions which are lightly loaded is suppressed or reduced.

Advantageously, the controller uses knowledge of the distribution of computing load among different cooling regions of the enclosure to determine where energy savings may be able to be made in the delivery of cooling resource to the enclosure. Optionally, the second cooling resource supply rate, the second cooling resource supply rate being the rate at which cooling resources are delivered to the enclosure by the or each air handling entity assigned to a cooling region in the second state from among the plurality of cooling regions, is held the same whilst the first cooling resource supply rate is decreased.

The first and/or second cooling resource supply rates may be fluid supply rates. Alternatively, the first and/or second cooling resource supply rates may be calculated by a metric which takes into account the setpoints (setpoint being the temperature of the cooled air expelled into the enclosure by the air handling unit) of the respective air handling units and the fluid supply rate. For example, the first cooling resource supply rate may be a function of the difference between an arbitrary reference temperature and the setpoint temperature of the or each air handling entity assigned to a cooling region in the first state (the difference increasing the further the setpoint temperature is below the arbitrary reference temperature) and the rate at which cooling fluid is expelled from the air handling entity. Such a function may be, for example, a product or a weighted product. Therefore, the cooling resource management module may be configured to increase the first/second cooling resource supply rate by reducing the setpoint of the or each air handling entity assigned to a cooling region in the first/second state and/or by increasing the rate at which the or each air handling entity assigned to a cooling region in the first/second state expels cooling fluid (air) into the enclosure. Similarly, the cooling resource management module may be configured to decrease the first/second cooling resource supply rate by increasing the setpoint of the or each air handling entity assigned to a cooling region in the first/second state and/or by decreasing the rate at which the or each air handling entity assigned to a cooling region in the first/second state expels cooling fluid into the enclosure.

The air handling entities may be uniform, for example, may produce the same output in terms of cooling fluid when operated with the same parameters (including one or more of setpoint, flow rate, etc). Alternatively, the air handling entities may be non-uniform. It may be that the cooling resource supply management module is configured, for each of the air handling entities, to store settings of configurable parameters at the air handling entity corresponding to each of a predetermined set of cooling resource supply rates, and to move between cooling resource supply rates by adjusting the configurable parameters as appropriate. The cooling resource supply rates for which settings of configurable parameters are stored may be consistent across each of the air handling entities, in order to compensate for non-uniformity.

The first cooling resource supply rate and the second cooling resource supply rate may each be considered to be the direct consequence of a configuration of settings for each of the air handling entities assigned to a cooling region in the pertinent state. Therefore, increasing or reducing a cooling resource supply rate is equivalent to adjusting settings of the air handling entities in such a way that the cooling resource supply rate is increased or reduced.

Cooling resource supply rates are determined by settings at the air handling entities (for a given environmental circumstance), and therefore the function of the cooling resource management module may be achieved by controlling settings at the air handling entities. The cooling resource management module may control settings (including setpoint and/or airflow rate) at the air handling entities by implementing the same settings and the same changes to settings at each of the air handling entities assigned to cooling regions in a particular state from among the first and second state. Effectively, each of the air handling entities assigned to cooling regions in the first state may be configured with the same settings, and each of the air handling entities assigned to cooling regions in the second state configured with the same settings. Alternatively, it may be that the settings are determined based on a desired performance characteristic, so that, for example, each of the air handling entities assigned to cooling regions in the same state are configured with settings intended to remove heat at the same rate, or to achieve a predetermined rate of temperature change in the cooling region. Thus the particular settings between air handling entities assigned to cooling regions in the same state may differ between air handling entities due to differences in their own physical characteristics, the physical characteristics of the cooling region to which they are assigned, and/or to the coupling between the air handling entity and the cooling region.

An air handling entity assigned to a cooling region is in fluid communication with the cooling region to which it is assigned. In addition, the air handling entity may be in fluid communication with other cooling regions in addition to the cooling region to which it is assigned. An air handling entity may be assigned to the cooling region to which it is the main source of cooling fluid. For example, air handling entities may supply air to a plenum underneath a raised floor, which air enters the enclosure through openings, grilles, and/or apertures. An example of settings controllable by the cooling resource management module is the size of openings connecting the cooling region to the air handling entity. Increasing the size of openings corresponds to increasing the supply of cooling resources to the cooling region, and decreasing the size of openings corresponds to decreasing the supply of cooling resources to the cooling region.

The assignment of air handling entities to cooling regions may be determined by the geometry of the cooling regions, the air handling entities, and any apparatus communicating fluid from the air handling entities to the cooling regions. The air handling entity assigned to a cooling region may be the main source of air to the cooling region, wherein the main source of air is the air handling entity from among the air handling entities that supplies the greatest volume of air to the cooling region (for example, given equivalence of settings including rate of expelled air at the air handling entities).

For example, the enclosure may comprise racks arranged in aisles, with computing entities housed in the racks. Each aisle or each n aisles (n being a positive integer) may be a cooling region, with an air handling entity assigned to the cooling region being disposed so that more of the cooled air expelled by the air handling entity enters the cooling region to which it is assigned than any of the other cooling regions. The cooling regions are non-overlapping, that is to say, a particular location within the enclosure is either in one cooling region or not in a cooling region at all, but cannot be in two cooling regions.

The controller simplifies the control of cooling resource supply rates by identifying whether each cooling region is in a first or second state, the identity being based upon the level of computing load being handled in the respective cooling region, and increasing or decreasing supply of cooling resources to all cooling regions identified as being in a particular one of the two states as a single control operation.

The controller unifies the functionality of a load migration module and a cooling resource management module so that changes in supply of cooling resources to different regions of the enclosure can be adjusted based upon the distribution of computing load and in particular can be decreased to cooling regions in a first (relatively lower loaded) state when a cooling region enters the first state that was previously in a second (relatively higher loaded) state.

The controller uses a single cooling condition to determine when the conditions in the enclosure are appropriate for decreasing or increasing the supply of cooling resources. The condition is whether or not a predetermined minimum number of computing entities is operating at a temperature above their respective maximum operating temperatures. If the cooling condition is satisfied, then more cooling is required, and the cooling management module is configured to use knowledge of which cooling regions are in the first and second states to determine in which regions of the enclosure to increase the supply of cooling resources. On the other hand, if the cooling condition is not satisfied, then the present level of cooling resource supply is adequate, and the cooling management module is configured to use knowledge of which cooling regions are in the first and second states to determine in which regions of the enclosure to decrease the supply of cooling resources. The predetermined minimum number may be one, so that if one or more computing entities are operating at above their respective predetermined maximum operating temperature, then the cooling condition is satisfied and the supply of cooling resources is increased. Correspondingly, only if each computing entity is operating at or below its respective predetermined maximum operating temperature is the supply of cooling resources decreased.

Optionally, the cooling resource supply management process further comprises: if the first indication is that the cooling condition is satisfied, the cooling resource management module is configured to increase a second cooling resource supply rate, the second cooling resource supply rate being the rate at which cooling resources are delivered to the enclosure by the or each air handling entity assigned to a cooling region in the second state from among the plurality of cooling regions.

If the number of computing entities operating at above their respective predetermined maximum operating temperatures is greater than or equal to the predetermined minimum number, then the cooling condition is satisfied, and the cooling resource management module is configured to adjust the supply of cooling resources to respond to the demand for more cooling (i.e. to respond to the fact that too many computing entities are overheating). The cooling resource management module may leave the first cooling resource supply rate unchanged while increasing the second cooling resource supply rate. The cooling resource management module is configured to utilise information held by the load management module to determine where best to devote cooling resources and therefore how to use energy more efficiently.

As an exemplary technique for adjusting supply rates, increasing the second cooling resource supply rate comprises incrementally increasing the second cooling resource supply rate and after each incremental increase, obtaining, as a second indication, a new indication of whether or not the cooling condition is satisfied from the temperature monitoring module, and repeating the incremental increasing and obtaining until either: the second cooling resource supply rate reaches a predetermined maximum; or the second indication is that the cooling condition is not satisfied.

Advantageously, incrementally increasing and checking in this way provides a mechanism to empirically determine the amount by which to increase the supply of cooling resources by air handling units assigned to cooling regions in the second state. The second cooling resource supply rate is increased until either it cannot be increased any further, or the number of computing entities operating at a temperature exceeding their respective predetermined maximum operating temperature is below the predetermined minimum, and the cooling condition is no longer satisfied (an indication that no further additional cooling resources are required).

As an optional additional step in the exemplary technique for adjusting supply rates: if the second cooling resource supply rate reaches the predetermined maximum, then the cooling resource supply management process further comprises increasing the first cooling resource supply rate.

The cooling resource management module is configured to respond to the fact that the air handling entities are delivering cooling resources to the enclosure at their maximum rate, but there are still more than the minimum number of computing entities operating at a temperature above their respective predetermined maximum operating temperature. Although air handling entities assigned to cooling regions in the first state primarily provide cooling resources to cooling regions in the first state, the cooling resources still reach the enclosure, and therefore will have some cooling effect upon other cooling regions. Therefore, once the maximum amount of cooling resources have been provided directly to cooling regions in the second (active) state by air handling entities assigned thereto, further cooling may be provided to those cooling regions by increasing the rate at which cooling resources are delivered to the enclosure by air handling entities assigned to cooling regions in the first (idle) state.

As a further exemplary technique for adjusting supply rates, increasing the first cooling resource supply rate comprises incrementally increasing the first cooling resource supply rate and after each incremental increase, obtaining, as a third indication, a new indication of whether or not the cooling condition is satisfied from the temperature monitoring module, and repeating the incremental increasing and obtaining until either:
the first cooling resource supply rate reaches a predetermined maximum; or
the third indication is that that the cooling condition is not satisfied.

Advantageously, incrementally increasing and checking in this way provides a mechanism to empirically determine the amount by which to increase the supply of cooling resources by air handling units assigned to cooling regions in the first state. The first cooling resource supply rate is increased until either it cannot be increased any further, or the number of computing entities operating at a temperature exceeding their respective predetermined maximum operating temperature is below the predetermined minimum, and the cooling condition is no longer satisfied (an indication that no further additional cooling resources are required).

Optionally, in embodiments in which the cooling resource supply management process includes obtaining a second indication, if the second indication is that the cooling condition is not satisfied, then the cooling resource supply management process further comprises reducing the first cooling resource supply rate, wherein: decreasing the first cooling resource supply rate comprises incrementally decreasing the first cooling resource supply rate and after each incremental decrease, obtaining, as a fourth indication, a new indication of whether or not the cooling condition is satisfied from the temperature monitoring module, and repeating the incremental decreasing and obtaining until either: the first cooling resource supply rate reaches a predetermined minimum; or the first indication is that the cooling condition is satisfied, whereupon the most recent incremental decrease of the first cooling resource supply rate is reversed.

An indication that the cooling condition is not satisfied corresponds to there being fewer than the predetermined minimum number of computing entities operating at above their respective predetermined maximum operating temperatures, hence it is determined that no further additional cooling is required. In fact, the above further steps of the process provide an empirical technique for determining how much the supply of cooling resources can be reduced, thus saving energy, without reducing the supply so much that the number of computing entities operating at above their respective predetermined maximum operating temperatures reaches the predetermined minimum. Reversing the most recent incremental decrease returns the first cooling resource supply rate to a rate at which the cooling condition was not satisfied, and hence the supply of cooling resources was sufficient to prevent the minimum number or more computing entities exceeding their respective predetermined maximum operating temperatures.

As an example of a particular technique for reducing the first cooling resource supply rate, reducing the first cooling resource supply rate comprises incrementally decreasing the first cooling resource supply rate and after each incremental decrease, obtaining, as a fifth indication, a new indication of whether or not the cooling condition is satisfied from the temperature monitoring module, and repeating the incremental decreasing and obtaining until either: the first cooling resource supply rate reaches a predetermined minimum; or the fifth indication that the cooling condition is satisfied, whereupon the most recent incremental decrease of the first cooling resource supply rate is reversed.

Advantageously, incrementally decreasing the supply rate of cooling resources and obtaining indications from the temperature monitoring module in this way provides a mechanism to empirically determine the amount by which to reduce the rate of supply of cooling resources by air handling units assigned to cooling regions in the first state. The first cooling resource supply rate is decreased until either it cannot be decreased any further, or the number of computing entities operating at a temperature exceeding their respective predetermined maximum operating temperature reaches or exceeds the predetermined minimum, and thus the cooling condition is longer satisfied (an indication that further additional cooling resources are required).

Once the first cooling resource supply rate has been adjusted as detailed above, the cooling resource management module is configured to determine whether any energy savings can be made by adjusting the supply of cooling resources from air handling entities assigned to cooling regions in the second state. For example: the cooling resource supply management process may further comprise reducing the second cooling resource supply rate, wherein reducing the second cooling resource supply rate comprises incrementally decreasing the second cooling resource supply rate and after each incremental decrease, obtaining, as a sixth indication, an indication of whether or not the cooling condition is satisfied from the temperature monitoring module, and repeating the incremental decreasing and obtaining until either: the second cooling resource supply rate reaches a predetermined minimum; or the sixth indication is that the cooling condition is satisfied, whereupon the most recent incremental decrease of the second cooling resource supply rate is reversed.

The above further steps of the process provide an empirical technique for determining how much the supply of cooling resources can be reduced from air handling entities assigned to cooling regions in the second state, thus saving energy, without reducing the supply so much that the number of computing entities operating at above their respective predetermined maximum operating temperatures reaches the predetermined minimum. Reversing the most recent incremental decrease returns the second cooling resource supply rate to a rate at which the cooling condition was not satisfied, and hence the supply of cooling resources was sufficient to prevent the minimum number or more computing entities exceeding their respective predetermined maximum operating temperatures.

Optionally, in techniques including incremental increasing or decreasing supply rates, the repeatedly incrementally decreasing and obtaining or the repeatedly incrementally increasing and obtaining includes waiting for a delay period between the incremental increasing or the incremental decreasing and the obtaining.

Advantageously, the delay period acts as a relaxation time during which the modification in settings is allowed to take effect and operating temperatures respond to the new cooling resource supply rates. The delay period may be predetermined, configurable by a system administrator or preset at the time of manufacture of the controller.

In addition, the repeatedly incrementally increasing/decreasing one of the two cooling resource supply rates and the obtaining, may include maintaining the other of the two cooling resource supply rates at the same rate while the repeated incremental increasing/decreasing and obtaining is performed.

As a further component of the controller, it may be that a storage module is included, the storage module being configured to store a cooling region population record identifying the cooling region in which each of the plurality of computing entities is located; wherein the load migration instruction module is configured to refer to the cooling region population record in order to determine the level of computing load being handled in each of the plurality of cooling regions.

The cooling region population record is an administrative tool that can be utilised by the load migration instruction module. For example, load reporting may be performed on a per computing entity basis, so that in order to identify cooling regions with capacity for additional load, or in some other way to determine to which cooling region load is to be migrated, a correspondence table or some other form of record linking computing entity identity and host cooling region is required.

The functionality of the load migration instruction module may include identifying one or more cooling regions to which load is to be migrated. Different quantities or characteristics of the cooling regions, and specifically the apparatus located therein, may be used as a basis for selecting targets for load migration. For example, it may be that cooling regions with the least spare capacity for additional computing load are identified and selected as targets for load migration (that is, cooling regions receiving load in an instructed migration), in order that the computing load tends to be concentrated at fewer cooling regions, and therefore cooling resources can be focussed at a smaller area of the enclosure than if the computing load were spread homogeneously among the cooling regions. Alternatively, the air inlet temperatures at racks housing the computing entities may be used as a basis for selecting load migration targets. For example: the load migration instruction module may be configured to obtain an indication of the air inlet temperature at each of the computing entities or at a rack housing each of the computing entities, and to instruct the redistribution of load from a first group of computing entities to a second group of computing entities, the air inlet temperature of the first group of computing entities or at the racks housing the first group of computing entities being higher than the corresponding air inlet temperature of the second group.

Advantageously, the procedure described above identifies locations within the enclosure at which cooling resources are already being received which have potential to remove the most heat from computing entities, and migrates load to the identified locations.

As an optional procedure which is to be executed by the computing entities themselves, when a redistribution of computing load is instructed by the load migration instruction module, the computing entities are configured to collectively execute a load migration algorithm in which computing load is iteratively migrated in a particular spatial direction or to one or more specified cooling regions.

The load migration instructing module may instruct a migration of load by initiating an algorithm among the computing entities. It may be that the computing entities are configured to perform a localised algorithm for migrating load, for example, self-organising into groups of computing entities (being subsets of the plurality computing entities) and cooperating among the group in order to determine how to migrate load among the group and to implement the determined migration. For example, groups may migrate load to the computing entities with the least capacity so that the computing load is concentrated at fewer computing entities and the remaining computing entities can enter a hibernation (or equivalent) mode. The geometry of the groups and the timing at which computing entities join groups may be configured to tend to move load in a particular spatial direction and/or toward specified cooling regions, so that after the algorithm is performed iteratively throughout the plurality of computing entities, the computing load becomes concentrated at particular cooling regions and other cooling regions have little or no load (and thus require little or no cooling). As a further example, the groups may be formed by subsets configured to migrate load within the subset in a particular spatial direction, so that the iterative formation of groups by different subsets of computing entities has the overall effect of moving computing load in a particular spatial direction, thereby tending to fill some cooling regions and vacate others.

In embodiments of an aspect of the present invention the computing environment is a physical environment in which the computing entities are computing devices and the air handling entities are air handling units.

In embodiments of another aspect of the present invention: a controller as defined above or as described or defined elsewhere in this document is provided for a particular computing environment, the particular computing environment being a simulation program configured to simulate fluid flow in the enclosure, operating temperature of the computing entities, and energy consumption rate of the air handling entities; wherein, when a redistribution of computing load is instructed by the load migration instruction module, the computing entities are configured to collectively execute a load migration algorithm in which computing load is iteratively migrated to a migration target, the migration target being one or more specified cooling regions from among the cooling regions, the load migration instruction module being configured to iterate through a plurality of different migration targets, and following the execution of the migration instructed for each migration target, the cooling resource management module is configured to perform the cooling resource supply management process defined above, and, for each migration target, to maintain a record of the energy consumption rate of the air handling entities at the end of the cooling resource supply management process.

Advantageously, controllers embodying the present invention can be used to control simulation programs in order to find settings to use in various circumstances in the physical environment modelled in the simulation program. The cooling regions which require the least energy to cool effectively can be determined, and the stored information enables the cooling regions to be ranked according to how much energy is required to cool them when they are loaded with computing load. This information can be used in the physical environment to determine to which cooling regions load should be migrated for the most efficient use of cooling resources.

Embodiments of another aspect of the present invention include a control method for a computing environment, the computing environment including: a plurality of computing entities housed within an enclosure, each computing entity having a predetermined maximum operating temperature, the enclosure comprising a plurality of cooling regions each having a portion of the plurality of computing entities located therein; and a cooling system comprising a plurality of air handling entities, each cooling region being assigned an air handling entity, each air handling entity being in fluid communication with the cooling region to which the air handling entity is assigned. The method comprises: maintaining an indication of which of the plurality of cooling regions are in a first state and which of the plurality of cooling regions are in a second state, the first state being handling less than a predetermined threshold level of computing load and the second state being handling more than the predetermined threshold level of computing load; when the indication is that one or more cooling regions are in the second state, instructing a migration of load among the cooling regions, the instructed migration causing the level of computing load handled at one of the one or more cooling regions in the second state to enter the first state; monitoring the operating temperature of each of the computing entities and indicating whether or not a cooling condition is satisfied, the cooling condition being that the operating temperature of the or each of a predetermined minimum number of computing entities from among the plurality of computing entities is above the respective maximum operating temperature; and performing a cooling resource supply management process. The cooling resource supply management process comprises: following execution of the instructed migration of load among the cooling regions, obtaining, as a first indication, an indication of whether or not the cooling condition is satisfied, and if the first indication is that that the cooling condition is not satisfied, reducing a first cooling resource supply rate, the first cooling resource supply rate being the rate at which cooling resources are delivered to the enclosure by the or each air handling entity assigned to a cooling region in the first state from among the plurality of cooling regions.

In such methods, the cooling fluid supply management process may be the cooling fluid supply management process defined or described elsewhere in this document.

Embodiments of another aspect of the present invention include a system comprising a plurality of computing entities housed within an enclosure, each computing entity having a predetermined maximum operating temperature, the enclosure comprising a plurality of cooling regions each having a portion of the plurality of computing entities located therein; a cooling system comprising a plurality of air handling entities, each cooling region being assigned an air handling entity, each air handling entity being in fluid communication with the cooling region to which the air handling entity is assigned; and a controller as defined above or as defined or described elsewhere in this document.

Furthermore, invention embodiments may include a suite of computer programs which, when executed by a distributed network of computing apparatuses, cause the distributed network of computing apparatuses to function as a system embodying the invention.

Furthermore, embodiments of the present invention include a computer program or suite of computer programs, which, when executed by a system of computing apparatuses including a distributed network of storage units cause the system to perform a method embodying the present invention.

Each of the functional modules may be realised by hardware configured specifically for carrying out the functionality of the module. The functional modules may also be realised by instructions or executable program code which, when executed by a computer processing unit, cause the computer processing unit to perform the functionality attributed to the functional module. The computer processing unit may operate in collaboration with one or more of memory, storage, I/O devices, network interfaces, sensors (either via an operating system or otherwise), and other components of a computing entity, in order to realise the functionality attributed to the functional module. The modules may also be referred to as units, and may be steps or stages of a method, program, or process.

Although the aspects (software/methods/apparatuses) are discussed separately, it should be understood that features and consequences thereof discussed in relation to one aspect are equally applicable to the other aspects. Therefore, where a method feature is discussed, it is taken for granted that the apparatus embodiments include a unit or apparatus configured to perform that feature or provide appropriate functionality, and that programs are configured to cause a computing apparatus on which they are being executed to perform said method feature.

In any of the above aspects, the various features may be implemented in hardware, or as software modules running on one or more processors. Features of one aspect may be applied to any of the other aspects.

The invention also provides a computer program or a computer program product for carrying out any of the methods described herein, and a computer readable medium having stored thereon a program for carrying out any of the methods described herein. A computer program embodying the invention may be stored on a computer-readable medium, or it could, for example, be in the form of a signal such as a downloadable data signal provided from an Internet website, or it could be in any other form.

Exemplary embodiments include those which dynamically adjust the settings of devices supplying cooling to cooling areas to adapt the supply of cool air to the spatial distribution of IT loads, thus enforcing parsimonious use of cooling resources while preserving the physical integrity of the servers. This is achieved by simultaneously monitoring VM location, airflow temperature and server CPU temperatures as three tasks are executed: a) VMs are migrated and concentrated in certain racks; b) idle servers are hibernated or turned off; c) operating conditions of air handling entities and other apparatus supplying cooled air to the enclosure are modified to save energy while providing adequate cooling to active servers.

Preferred features of the present invention will now be described, purely by way of example, with reference to the accompanying drawings, in which:-
Figure 1 is an illustration of a system embodying an aspect of the present invention including a computing environment and a controller embodying another aspect of the present invention;
Figure 2 is a schematic representation of a controller embodying the present invention;
Figure 3 is an example of a computing environment to which embodiments may be applied;
Figure 4 is a schematic representation of an architecture embodying the present invention;
Figures 5 to 7 are flow charts representing alternative methods, programs, or process embodying the present invention or being performed by embodiments; and
Figures 8a and 8b show temperature distribution in the computing environment of Figure 3 before and after execution of a cooling resource supply management process and instructed load migration.

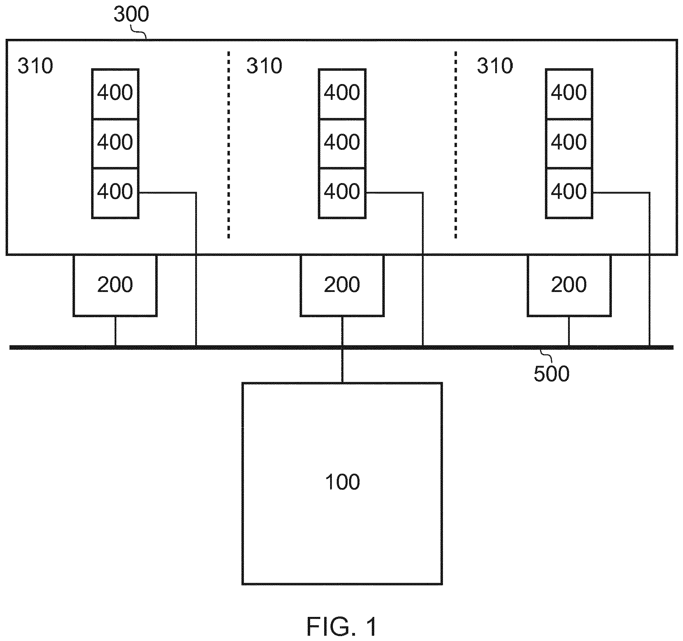

Figure 1 illustrates a computing environment and controller embodying the present invention. An enclosure 300 is divided into a plurality of cooling regions 310. Each cooling region 310 is assigned an air handling entity 200. The assignment of air handling entity 200 to a particular cooling region 310 is represented in Figure 1 by the proximity of the air handling entities 200 to the cooling regions 310 to which they are assigned. Each cooling region 310 contains a plurality of computing entities 400. Each of the computing entities 400 and the air handling entities 200 are connected by a communications network 500 which also connects the computing entities 400 and the air handling entities 200 to the controller 100. The communications network 500 is configured to transfer data between the entities and modules it connects, and may be wired, wireless, or a combination of both. For simplicity, only a single computing entity 400 per cooling region 310 is illustrated with a connection to the communications network 500. However, one or more of the computing entities 400 per cooling region 310 is configured to communicate with the controller 100.

The enclosure 300 may be, for example, a data centre hall, or some other room or contained volume. The plurality of computing entities 400 are housed within the enclosure, optionally on racks or some other form of support structure. Optionally, the racks are arranged in lines to form aisles between lines of racks.

The dashed lines between cooling regions 310 represent the boundaries between the cooling regions. The boundaries may be physical boundaries which are partially or entirely impermeable to gas. Alternatively, the boundaries may be notional boundaries and air may be able to flow freely between cooling regions 310.

The communications network 500 and the controller 100 are illustrated as being outside of the enclosure 300. However, the communications network may be partially within and partially without the enclosure 300, or entirely within the enclosure 300. Furthermore, the controller 100 may be disposed within the enclosure 300.

The computing entities 400 may be computing devices such as servers (also referred to as blades), storage servers, computers, or some other form of device comprising a computer processing unit.. The computing entities 400 may be uniform. The maximum operating temperature may be uniform across the plurality of computing entities, or may differ depending on the particular operating characteristics of each computing entity.

The air handling entities 200 may be located within the enclosure or may be located elsewhere and connected to the enclosure 300 via ductwork and/or apertures and openings allowing cooled air from the air handling entities 200 to flow into the enclosure 300. The cooling system comprises the air handling entities 200 and any ductwork and openings and/or apertures.

The controller 100 may be realised by a single entity such as a computing device or server, or may be realised by more than one computing device operating collaboratively, for example, as a layer of a control protocol. Therefore, each functional module may be executed by components belonging to a plurality of computing devices, and the functional modules may be provided by more than one computing device.

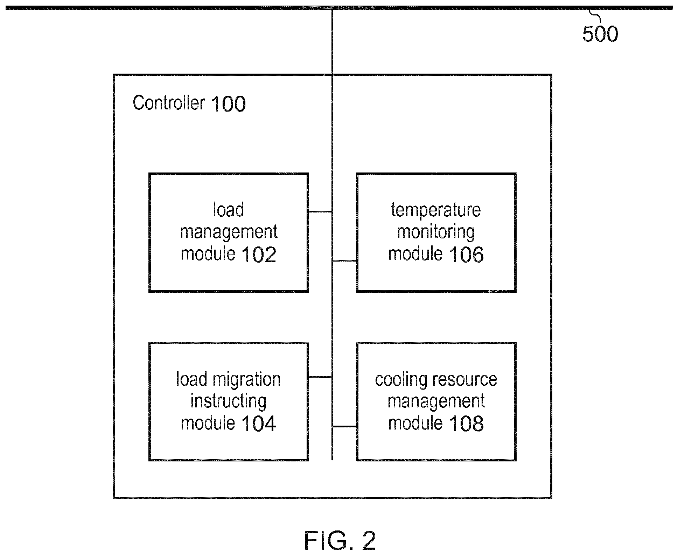

Figure 2 is a schematic representation of a controller 100 embodying the present invention. The controller 100 comprises a load management module 102, a load migration instructing module 104, a temperature monitoring module 106, and a cooling resource management module 108. The load management module 102, load migration instructing module 104, temperature monitoring module 106, and cooling resource management module 108, may be referred to collectively as the modules or the functional modules. The functional modules are illustrated as being connected to one another, which is representative of the functional modules being configured to transfer data among themselves, and are connected to the communications network 500 by which information can be transferred to and received from the air handling entities 200 and the computing entities 400.

The load management module 102 is configured to maintain and indication of which of the plurality of cooling regions 310 are in a first state, and which are in a second state. Cooling regions 310 in the first state are handling a computing load below a predetermined threshold and cooling regions 310 in the second state are handling a computing load above the predetermined threshold. The mechanism for obtaining the indications may be a reporting mechanism, whereby, either periodically or in response to a trigger such as a request from the load management module 102 or a change in load being handled, each cooling region 310 provides information to the load management module 102 which information the load management module 102 is configured to use to generate a value representing the level of (or amount of) computing load being handled at the cooling region 310 and to compare the value with the predetermined threshold to determine whether the cooling region is in the first state or the second state. Such information may be, for example, aggregate power consumption of computing entities in the cooling region, or may be based upon a reporting protocol such as IPMI. Alternatively, the comparison with the threshold may be performed at the cooling regions 310 themselves, so that the information received at the load management module 102 is simply an indication of, for each cooling region 310, whether or not the level of computing load being handled at the cooling region exceeds the predetermined threshold.

Throughout this document, computing load being handled by a cooling region is taken to mean an amount (a rate) of processing being performed by computing entities located in the cooling region, or an amount or proportion of computing (hardware) resources belonging to computing entities in the cooling region that is currently attributed to a job or task (and thereby considered occupied). Generally, since computing entities are defined as belonging to a cooling region, functions performed by the computing entities can accurately be defined as being performed by the cooling region.

The predetermined threshold may be set by a database administrator at system set up time, and may be configurable based on implementation scenarios. The predetermined threshold may be an absolute value that is fixed across the plurality of cooling regions 310, or may be calculated per cooling region 310, for example, based on the (number and capacity of) computing entities located in each cooling region 310.

The load migration instructing module 104 is configured to instruct a migration of load among the cooling regions. The actual involvement of the load migration instructing module may be to simply initiate a localised algorithm performed locally at the computing entities 400 to determine how to migrate load, so that the load migration instructing module 104 does not specify load donors and load recipients. The localised algorithm may include instructions determining the composition of groups among which load is migrated, with each group being a subset of the plurality of computing entities 400, and the groups being formed so that some of the groups include computing entities 400 from more than one cooling region 310. The localised algorithm initiated by the load migration instructing module may be an algorithm which moves computing load among cooling regions 310, so that a consequence of initiating the algorithm is that computing load is transferred between cooling regions 310, and one or more cooling regions 310 not previously in the first state transfer sufficient computing load to other cooling regions to enter the first state. The localised algorithm may be an algorithm in which computing entities from among the plurality of computing entities 400 form into groups and, within the formed groups, move computing load toward a particular location or end of the enclosure. Exemplary localised algorithms include that described in European patent application EP13151211.3 or that described in EP13186667.5. The localised algorithms may be iterative, and the load migration instructing module 104 may be configured to initiate iterations and to determine how many iterations of the algorithm should be performed and when. Alternatively or additionally, the load migration instructing module may be configured to perform a centralised algorithm to determine how to redistribute computing load among the cooling regions.

In a first example of a localised algorithm, a computing entity is configured to operate as a particular computing entity among the plurality of interconnected computing entities 400, the computing entity comprising:
- a load information obtaining unit configured to obtain, from the particular computing entity and from the or each of a group of one or more other computing entities from among the plurality of interconnected computing entities, load information representing the current computational load of the computing entity from which the information is obtained; and
- a load redistribution determination unit configured, in dependence upon the obtained load information, to determine whether or not to redistribute computational load among the particular computing entity and the group, and if it is determined to redistribute computational load, to determine the redistribution and to instruct the determined redistribution.

In this first example, the redistribution is of computational load from the particular computing entity to one of the group of computing entities. The obtained load information from the group of computing entities includes capacity information representing the current capacity of the computing entity from which the load information is obtained to perform computational load additional to its current computational load. The load redistribution determination unit is configured to determine, based on the obtained load information, the computing entity having the smallest capacity from among the computing entities of the group that have a non-zero current capacity, and to select the determined computing entity 400 as a recipient computing entity of the redistribution. The load redistribution determination unit is configured to select an amount of computational load to redistribute in the instructed redistribution, the selected amount being equal to the current computational load of the particular computing entity, unless the current capacity of the recipient computing entity is less than the current computational load of the particular computing entity, in which case the selected amount is equal to the current capacity of the recipient computing entity 400. The formation of groups is such that, for at least some of the computing entities 400 as the particular computing entity, the group includes computing entities from more than one cooling region 310.

In the first example, optionally, each of the plurality of interconnected computing entities 400 has a designated position in the or each of n dimensions, and for each computing entity, the group is formed of the computing entities designated with the adjacent positions in the or each of the n dimensions. For example, n is equal to 2 or 3, each of the n dimensions corresponds to a spatial dimension, and the designated position of each computing entity in the n dimensions represents the spatial position of the computing entity relative to the other computing entities.

In the first example, it may be that each of the plurality of computing entities 400 are configured, in turn, to operate as the particular computing entity 400. Furthermore, the order in which the plurality of interconnected computing entities 400 operate as the particular computing entity may be determined by the physical location of the computing entities.

In a second example of a localised algorithm, each computing entity 400 among a plurality of interconnected computing entities 400 has a designated position in the or each dimension of an n-dimensional array of designated positions, the algorithm comprising, individually, at one or more computing entities per designated position in a series of designated positions in one dimension of the n-dimensions, in which one dimension one direction is assigned as a load transfer direction, executing a process including:
- obtaining an indication of current capacity for additional load at the or each member of a group of one or more computing entities 400 from among the plurality of computing entities 400; and
- transferring load from the executing computing entity to a member of the group at which it is indicated that there is capacity for additional load, wherein membership of the group is restricted to a computing entity or computing entities to the load transfer direction side of the executing computing entity in the one dimension.

Optionally, in the second example, n is greater than or equal to two, and membership of the group is restricted to a computing entity or computing entities within a predetermined number of designated positions of the individual computing entity in the one dimensions and/or each of the other n-dimensions than the one dimension.

The second exemplary algorithm may be performed as a sequence of more than one iterations, wherein, for each iteration the series of designated positions is the first designated position to the penultimate designated position in the load transfer direction of the one dimension, and each computing entity in each of the series of designated positions has a position in a predetermined sequence in which the computing entities 400 are to execute the process, and the computing entities 400 are configured to execute the process in turn according to the predetermined sequence omitting computing devices having a zero current load at their turn.

The temperature monitoring module 106 is configured to monitor the operating temperature of each of the computing entities and to indicate whether or not a cooling condition is satisfied, the cooling condition being that the operating temperature of the or each of a predetermined minimum number of computing entities from among the plurality of computing entities is above the respective maximum operating temperature.

The temperature monitoring module 106 may be connected to a temperature sensor at each of the computing entities 400, or may be configured to receive information from the operating systems of the computing entities 400 which themselves include temperature sensors. The temperature sensors report the operating temperature of the respective computing entity to the temperature monitoring module 106. The temperature monitoring module 106 may be configured to store values representing the maximum operating temperatures of each of the computing entities for comparison with the reported operating temperatures. In a first exemplary technique, the temperature monitoring module 106 may be configured to receive temperature measurements from the or each of the computing entities 400 and to compare the received temperature measurements with the respective predetermined maximum operating temperature(s). Alternatively, in a second exemplary technique, the comparison may be performed locally at the computing entity 400, and the temperature monitoring module 106 is configured to obtain a notification when a computing entity 400 from among the plurality of computing entities 400 is operating at a temperature in excess of the respective predetermined maximum operating temperature. Using either technique, or a combination of both exemplary techniques, the temperature monitoring module 106 is configured to maintain a record of the current number of computing entities operating at a temperature in excess of the respective predetermined maximum operating temperature of the computing entity. When the current number exceeds the predetermined minimum number of computing entities, the cooling condition is satisfied (an indication that more cooling is required). When the current number is less than the predetermined minimum number, the cooling condition is not satisfied (i.e. additional cooling is not required), and the cooling resource management module 108 is configured to reduce energy consumption by changing the cooling resource supply rates.

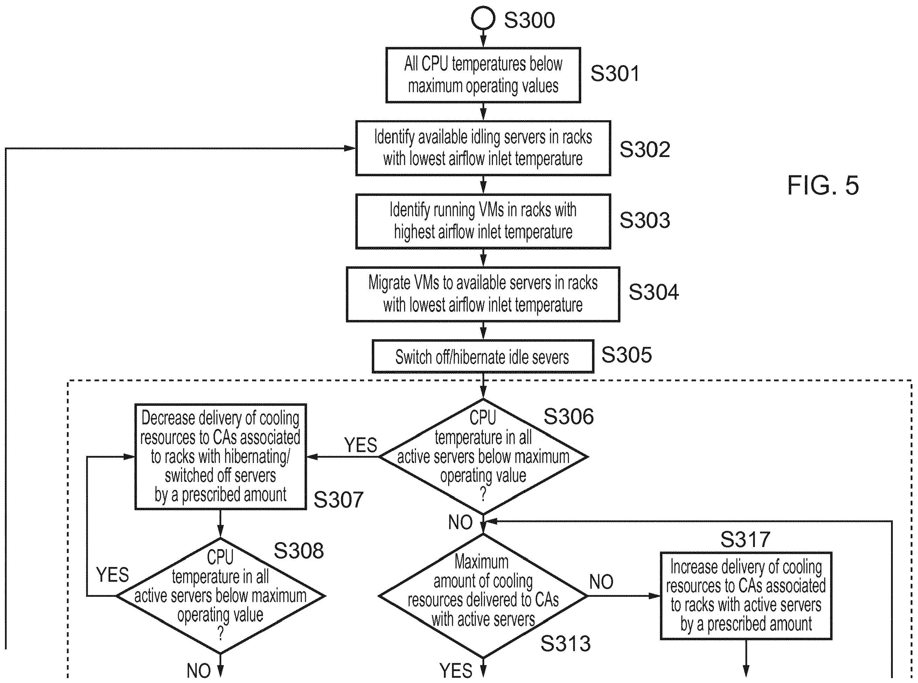

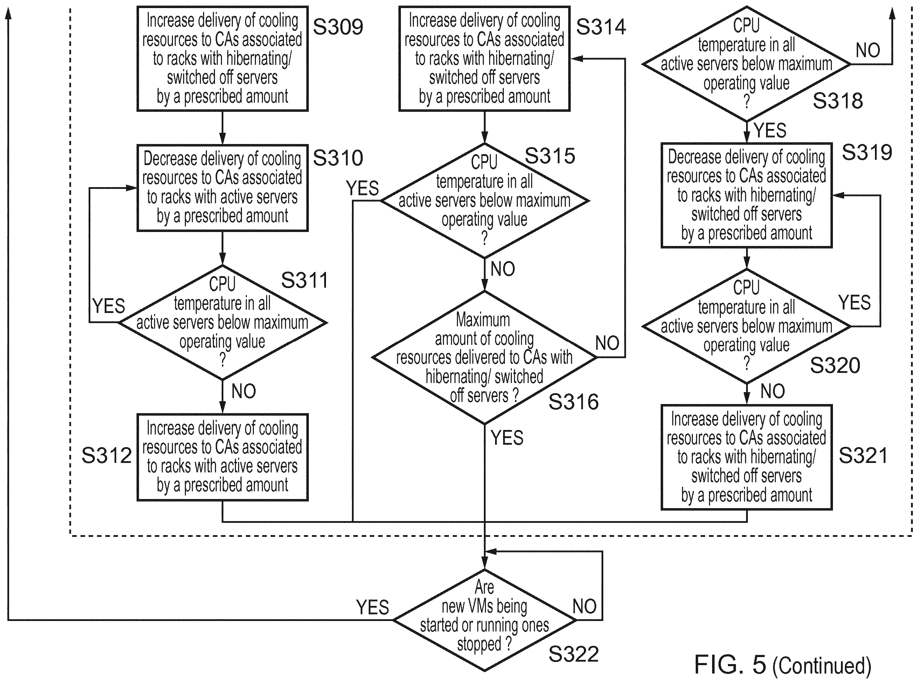

The cooling resource management module 108 is configured to perform a cooling resource supply management process comprising at least, obtaining, as a first indication, an indication of whether or not the cooling condition is satisfied, and if the first indication is that that the cooling condition is not satisfied, reducing a first cooling resource supply rate, the first cooling resource supply rate being the rate at which cooling resources are delivered to the enclosure by the or each air handling entity assigned to a cooling region 310 in the first state from among the plurality of cooling regions 310. Additional steps which may form part of the cooling resource supply management process are set out on Figure 5 and described in more detail below. The cooling resource management module 108 is configured to adjust (increase or decrease) cooling resource supply rates by changing configurable settings at air handling units assigned to the cooling regions 310 (including temperature setpoint and rate of cooled air expulsion) and/or changing configurations of apertures and openings to increase or decrease the resistance to cooled air entering a cooling region 310.

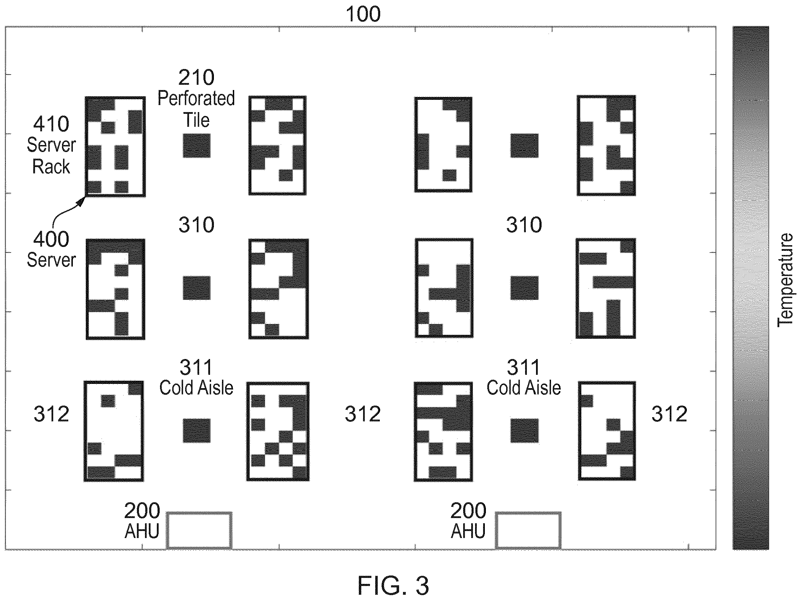

Figure 3 shows a simplified floor plan of a computing environment which the controller of Figure 2, or as described elsewhere in this document, is suitable to control. The computing environment includes a data centre hall 300 (exemplary of an enclosure), which is divided down the middle into two cooling regions 310, one on the right hand side and one on the left hand side. An exemplary spatial distribution of server racks 410, servers 400 (exemplary of computing entities and represented by smaller squares on the server racks, with active servers marked and non-active servers not marked), air handling units 200 (exemplary of air handling entities), one air handling unit 200 being provided for each cooling region 310, and perforated tiles 210. The perforated tiles 210 allow air expelled by the air handling units 200 to enter the data centre hall 300, and their arrangement in a line defines a cold aisle 311 within each cooling region 310.

The active servers 102 are relatively hot in comparison to the perforated tiles in the cold aisles 106 and 107.

For simplicity, in the computing environment illustrated in Figure 3, it is assumed that each server supports at most one VM and that in an initial stage there is a pre-existing spatial distribution of VMs, as represented by some of the servers 400 being blocked out (representing heat and therefore the presence of computing load) within the server racks 410. A VM is a virtual machine, and is an allocation of computing hardware resources to a particular task or service. A VM is exemplary of a unit of computing load. A VM can be migrated by changing the allocation of computing hardware resources to the particular task or service, and in particular by changing to computing hardware resources belonging to a different server. The blank spaces within the server racks 410 indicate that a VM is not being hosted at that space. For the sake of simplicity a two-dimensional distribution of servers 400 and VMs within each rack is assumed: in an actual data centre this distribution may be three-dimensional, with servers 400 disposed vertically within the racks 410. Nevertheless, the physical principles on which the controller 100 operates remain valid irrespective of the particular spatial distribution of servers 400 within racks 410.

Air handling units 200 force cool air (exemplary of cooling resources) into a raised floor underneath the data centre hall 300; this air is then supplied to the servers 400 after entering the data centre hall 300 through the perforated tiles 210. In the exemplary computing environment of Figure 3, server racks 410 and perforated tiles 210 are arranged into lines forming cold aisles 311, into which cold air flows from the perforated tiles 311 to server intakes, and hot aisles 312 where hot air is discharged from the server exhausts. Airflow distribution patterns in the data centre hall 300 are influenced by the spatial distribution of VMs, pressure distribution within the raised floor and by the disposition of the perforated tiles 210; the pressure distribution within the raised floor is in turn controlled by the AHU air flow rates (exemplary of cooling fluid supply rates, and when combined with temperature of the air exemplary of cooling resource supply rates) and by the particular geometry of the raised floor. In the example of Figure 3, the perforated tiles 210 can be considered cold, and the active servers 400 (those that are blocked out) can be considered hot.

The cooling regions can also be referred to as cooling areas or cooling zones, and may refer to a particular AHU 200 and to the collection of associated perforated tiles 210 that constitute a cold aisle 311 neighbouring the particular AHU 200. That is to say, the cooling region is a cold aisle 311 that is supplied cooled air primarily by the AHU 200. , and the servers 400 for which the cold aisle 311 is the main source of cooling resources. In this sense, the AHU 200 is considered to be assigned to the cooling region. Adjustments to the rate at which an AHU 200 supplies cooling resources to the cooling region to which it is assigned could include but are not limited to changes in AHU setpoint (airflow rate and temperature), opening & closing of louvers, and/or repositioning or suppression of perforated tiles. In the example of Figure 3, all AHUs 200 supply cooled air to the same common volume under the raised floor, and thus a certain degree of coupling can be expected between the different cooling regions 310. For example, if the operating conditions of one of the AHUs 200 are changed, the effects of this change will affect airflow conditions in both cooling regions 310. The coupling between cooling regions 310 and their assigned AHUs 200 could be expressed as a matrix whose elements can be obtained through airflow simulation or measurement: for instance, in the exemplary data centre represented in Figure 3, a 2x2 coupling matrix could be used to describe how changes in a particular AHU affect each cooling region 310.

The cooling resource supply management process included in or carried out by embodiments utilises the coupling between IT equipment placement, IT load placement and settings controlling cooling resource supply rates in a data centre hall to reduce the energy consumed both by the IT equipment and the air conditioning system by modifying the rates at which cooling resources are supplied to cooling regions assigned thereto in response to changes in the distribution of computing load.

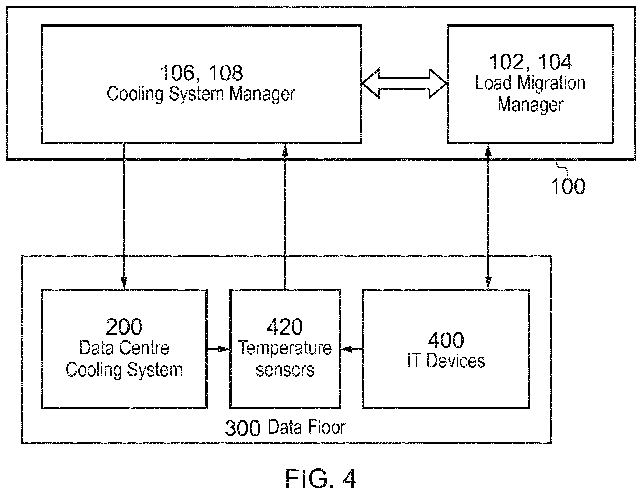

Figure 4 is a schematic representation of an architecture of an embodiment. A controller 100 includes a cooling system manager which combines the functionality of the temperature monitoring module 106 and the cooling resource management module 108. The controller 100 also includes a load migration manager which combines the functionality of the load management module 102 and the load migration instructing module 104. The cooling system manager is configured to receive information about the spatial distribution of VMs from the load migration manager as well as information from temperature sensors 420 about a) the temperature of the air supplied by the cooling system 200; and/or b) the CPU and airflow inlet temperatures of IT devices 400. The data centre cooling system is exemplary of the plurality of air handling units. The IT devices 400 are exemplary of the computing entities. A combination of the CPU and inlet temperatures are used to estimate the actual heat transfer that takes place within each IT device. Airflow and server CPU temperatures can be tracked through a data centre management system based on the Intelligent Platform Management Interface (IPMI) technology such as the one proposed in European Patent Application 1194408.8 "A data centre thermal and power management system using ACPI/IPMI". The cooling system manager uses this temperature information as well as information about the spatial distribution of VMs supplied by the load migration manager to adjust the settings of the data centre cooling system 200. The load migration manager uses information from the cooling system manager 200 to determine the VM migration policy that will be applied on the IT devices 400. That is to say, the migration of load is instructed in a manner which migrates load to locations of the data centre floor 300 (exemplary of an enclosure) at which there are available cooling resources, and the cooling system is controlled in a manner which is dependent upon the spatial distribution of VMs on the data floor.

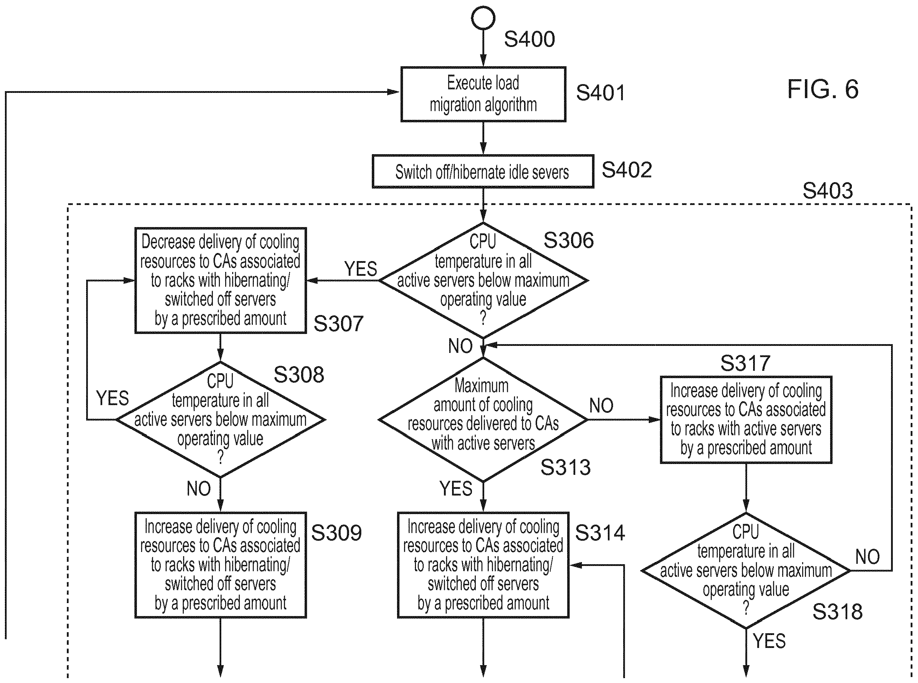

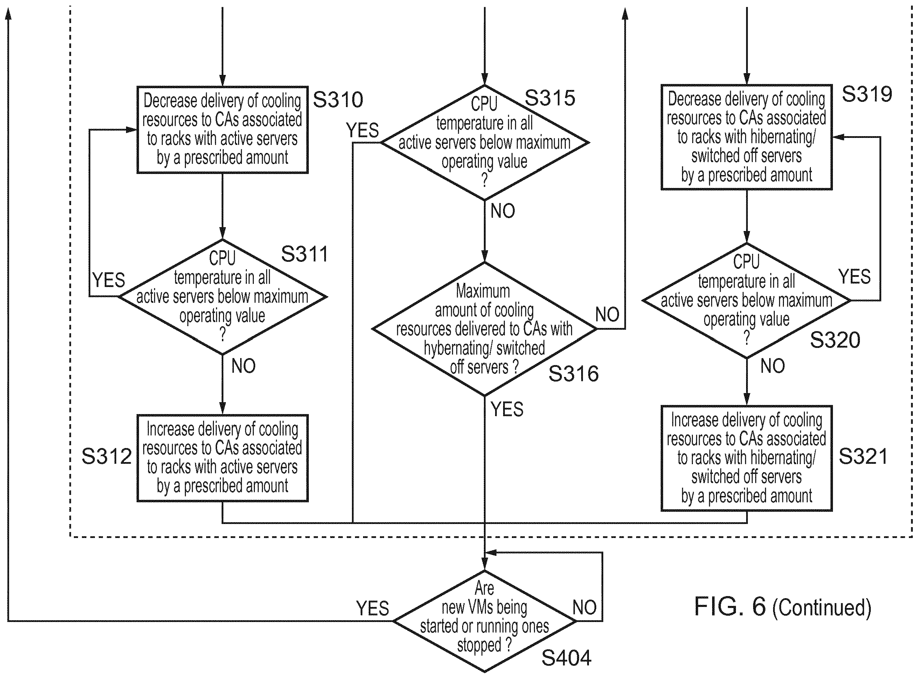

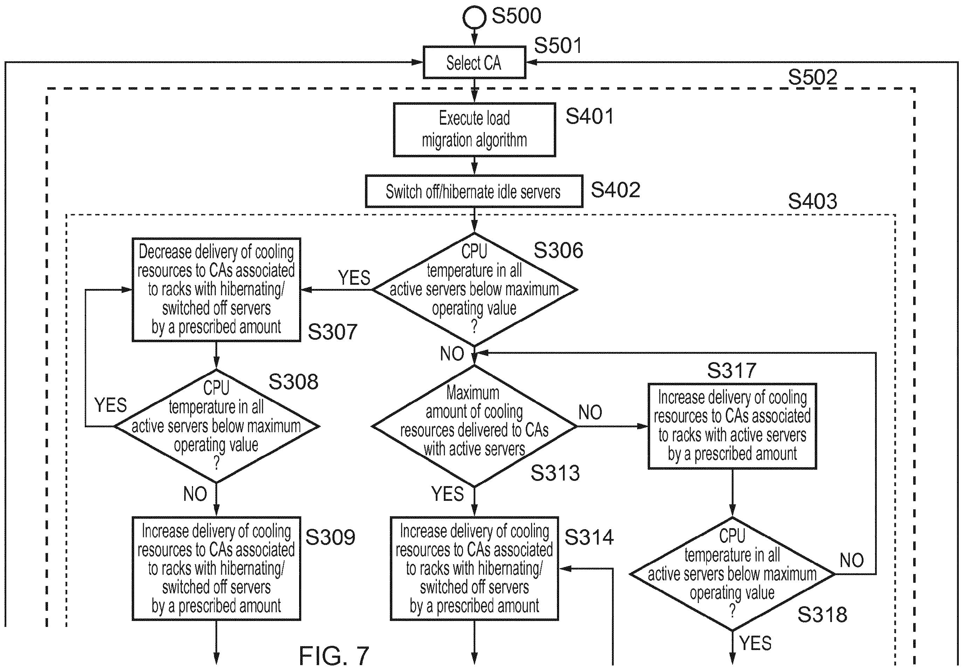

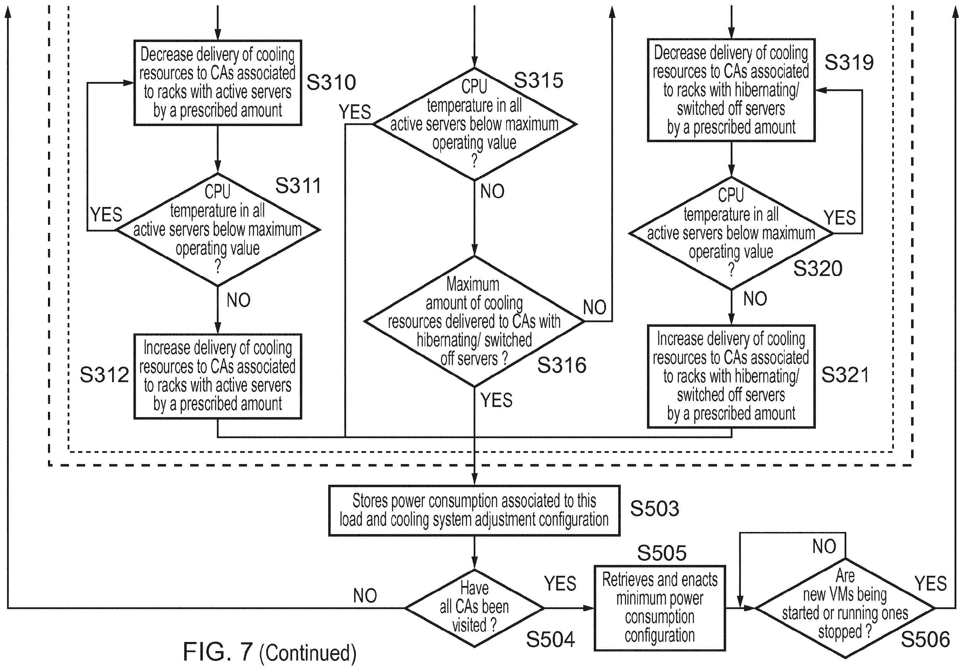

Figures 5 to 7 are flowcharts representing alternative exemplary control procedures of embodiments. The steps within the dashed box of Figures 5 and 6, and within the inner dashed box of Figure 7, are exemplary of the cooling resource supply management process. Steps given the same reference sign in more than one Figure are the same in each of those Figures. The abbreviation CA (cooling area) is used as an equivalent to cooling region. The expression 'CAs associated to racks with hibernating/switched off servers' is used to refer to cooling regions in the first state, and the expression 'CAs with active servers' is used to refer to cooling regions in the second state. VMs are exemplary units of computing load.

The exemplary process of Figure 5 begins at step S300 with a pre-existing spatial distribution of VMs such as that shown in Figure 3. An underlying assumption is that the cooling system 200 can provide sufficient cooling resources to prevent servers 400 overheating regardless of the spatial distribution of VMs. Again, in this exemplary process, VMs are exemplary of computing load. In this exemplary process, the predetermined minimum number of computing entities (which are servers in this example) operating at above their respective predetermined maximum operating temperature in order for the cooling condition to be satisfied is 1. As specified at S301, in an initial state all server CPU temperatures (wherein the server CPU temperature is taken as the operating temperature of the computing entity) remain below a previously set maximum operating temperature (MOT). The MOT value may be set at and stored by the controller 100. For example, the following factors may be taken into account in setting the maximum operating temperature for a computing entity: a) reduce the probability of CPU damage by including a safety margin below the maximum CPU temperature specified by the manufacturer (e.g. CPU temperature must always be 10°C below its maximum rated value); b) ensure adequate heat transfer from the CPU to the cooling system.

At step S302 the controller 100 identifies servers with capacity for additional load located in racks with the lowest airflow intake temperature: the location of these racks will depend on a number of factors such as raised floor geometry, rack and server positioning, placement of raised tiles, AHU settings and spatial computing load distribution, amongst others. The flow continues at step S303, where VMs running in servers located in rack positions with the highest airflow intake temperature are identified as candidates for migration by the controller 100. For example, this identification step could include a ranking process e.g. computing load on servers with the highest CPU temperatures would be placed first in the migration queue (i.e. would be migrated soonest). Steps S302 identifies locations in the data centre where servers are less likely to overheat, for example, due to asymmetries in the distribution of cooling resources to the data floor. Step S303 identifies locations where servers have a greater likelihood of overheating (e.g. at the top of server racks).

At step S304 the migration of the VMs identified in step S303 takes place under control of the load migration instructing module 104. This migration continues until the servers identified as having capacity in step S302 have been occupied. At step S305 the servers that no longer handle any computing load as a consequence of the migration performed in S304 are either hibernated or switched off by the controller 100.

Steps S306 to S321 are an exemplary cooling resource supply management process: a heuristic procedure to determine whether and how the energy consumption of the cooling system 200 can be reduced as a consequence of the change in spatial distribution of computing load resulting from the load migration. The exemplary cooling resource supply management process reduces the supply of cooling resources to different cooling regions 310 whilst ensuring that servers 400 do not overheat. The exemplary cooling resource supply management process comprises gradually changing the amount of cooling resources that is delivered to the data centre hall 300 by the air handling units 200 assigned to different cooling regions 310.

The exemplary cooling resource supply management process starts at step S306 by verifying that CPU temperatures in all active servers are below the MOT. Step S306 is an example of the step of obtaining the first indication from the temperature monitoring module 102. If the temperature of all servers is below the MOT the cooling condition is not satisfied (that is to say, there is no indication that more cooling is required), and the flow continues to step S307.

At step S307 the supply of cooling resources from air handling entities 200 assigned to cooling regions 310 in the first state is decreased by a pre-established amount; this amount can be established by the operator or found through simulation, and it should be small enough to ensure a gradual change in the heat removed from computing entities in said cooling regions 310.

The flow continues at step S308, where once again the control system 200 verifies that all CPU temperatures are below the MOT, that is to say, obtains an indication from the temperature monitoring module 106 and checks whether the cooling condition is satisfied. Step S308 is an example of the step of obtaining the fifth indication from the temperature monitoring module 106 mentioned elsewhere in this document. If all the servers are operating at below their respective MOTs, then the cooling condition is not satisfied, and so the flow returns to step S307 to investigate the effect of further decreasing the supply of cooling resources by air handling entities assigned to cooling regions in the first state. Steps S307 and S308 constitute an iterative cycle that continues until either no further decrease is possible/allowed, or the temperature of any active server rises above the MOT. In the second case, the cooling condition is satisfied, and the most recent decrease in the supply of cooling resources by air handling entities assigned to cooling regions in the first state is undone at step S309. This returns the supply to the last known supply rate at which the cooling condition was not satisfied, and hence the amount of cooling resources being supplied to the enclosure was adequate/sufficient to keep all CPU temperatures below their respective MOTs.

The flow continues at step S310, where the supply of cooling resources to the enclosure 300 by air handling entities 200 assigned to cooling regions 310 in the second state is decreased by a pre-determined amount. At step S311 another check on the cooling condition is performed. Step S311 is an example of the step of obtaining the sixth indication from the temperature monitoring module. If the server CPU temperatures remain below the MOT at step S311, then the cooling condition is not satisfied, and the flow returns to step S310 to further reduce this supply. Steps S310 and S311 constitute an iterative cycle that continues until either no further decrease is possible/allowed, or the temperature of any active server rises above the MOT. In the second case, the cooling condition is satisfied, and the most recent decrease in the supply of cooling resources by air handling entities assigned to cooling regions in the second state is undone at step S312.

If the CPU temperature of any server rises above the MOT after load migration has taken place at step S305, then the cooling condition is satisfied and the flow is diverted to step S313 at step S306. If the amount of cooling resources delivered to the enclosure 300 by air handling entities 200 assigned to cooling regions 310 in the second state has not reached its maximum at step S313, then the rate at which said air handling entities 200 supply cooling resources is increased by a pre-established amount at step S317. At step S318 the CPU temperatures of all active servers are verified again, and if any of them is still above the MOT then the cooling condition is still satisfied and the flow returns to step S313. Step S318 is an example of the step of obtaining the second indication from the temperature monitoring module 106 mentioned elsewhere in this document. If, at step S318, it is determined that all servers have temperatures below their respective MOTs then the cooling condition is no longer satisfied, so the process sets about investigating whether or not the supply of cooling resources can be reduced.

At step S319 the supply of cooling resources from air handling entities 200 assigned to cooling regions 310 in the first state is decreased by a pre-established amount; this amount can be established by the operator or found through simulation, and it should be small enough to ensure a gradual change in the heat removed from computing entities in said cooling regions 310.

The flow continues at step S320, where once again the control system 200 verifies that all CPU temperatures are below the MOT, that is to say, obtains an indication from the temperature monitoring module 106 and checks whether the cooling condition is satisfied. Step S320 is an example of the step of obtaining the fourth indication from the temperature monitoring module 106 mentioned elsewhere in this document. If all the servers are operating at below their respective MOTs, then the cooling condition is not satisfied, and so the flow returns to step S319 to investigate the effect of further decreasing the supply of cooling resources by air handling entities assigned to cooling regions in the first state. Steps S319 and S320 constitute an iterative cycle that continues until either no further decrease is possible/allowed, or the temperature of any active server rises above the MOT. In the second case, the cooling condition is satisfied, and the most recent decrease in the supply of cooling resources by air handling entities assigned to cooling regions in the first state is undone at step S321. This returns the supply to the last known supply rate at which the cooling condition was not satisfied, and hence the amount of cooling resources being supplied to the enclosure was adequate/sufficient to keep all CPU temperatures below their respective MOTs.

If the amount of cooling resources delivered to CAs with active servers has reached its maximum at step S313 the flow continues to step S314, where the rate at which air handling entities 200 assigned to cooling regions 310 in the first state supply cooling resources is increased by a pre-established amount. Owing to the effects previously explained in the discussion of the coupling matrix, the cooling resources supplied by air handling entities 200 assigned to cooling regions 310 in the first state may remove heat from computing entities 400 in cooling regions in the second state. At step S315 another check on the cooling condition is performed. Step S315 is an example of the step of obtaining the third indication from the temperature monitoring module mentioned elsewhere in this document. The CPU temperatures of all servers are verified, and if all of them are below the MOT, the cooling condition is not satisfied, and so no further increase in the rate of delivery of cooling resources is required and the flow continues to step S322. On the other hand, if the cooling condition is satisfied, then the flow proceeds to step S316. If the amount of cooling resources delivered to the enclosure by air handling entities assigned to cooling regions in the first state has reached its maximum, the flow continues at step S322 (since the data centre is properly designed, all servers must have reached a safe CPU temperature at this point, and in any case). If not the flow returns to step S314 to further increase the rate at which air handling entities 200 assigned to cooling regions 310 in the first state supply cooling resources.

Once the flow proceeds to step S322 it remains there as long as no new VMs are initiated or no running VMs are stopped. If new VMs are being initiated or running VMs stopped (or a predetermined minimum number of new VMs are started or running VMs stopped) the flow then proceeds to step S302, re-starting the process of VM migration and cooling resources supply adjustment in order to minimise energy consumption as described so far.

Those steps involving adjustments to the cooling system (S307, S309, S310, S312, S314, S317, S319 and S321) may include a large enough time delay so that transients in supply air temperature die out. The rise in CPU temperature contemplated in steps S309, S312 and S319 is small enough to prevent CPU damage; this can be achieved by providing a large enough safety margin in the MOT value and by changing the supply of cooling resources by small enough steps.

Figure 6 shows another exemplary control procedure of embodiments. An assumption is that adequate cooling is provided at step S400 so that no servers 400 are already overheating. The flow starts at step S400 with a pre-existing VM spatial distribution. At step S401 a localized algorithm is executed in order to concentrate VMs in a given area of the data floor: exemplary algorithms that can be used for these purpose are those described above as the first and second examples of localized algorithms. After the algorithm has been executed (or after a predetermined number of iterations of the localized algorithm through the plurality of computing entities 400) the flow continues to step S402, where servers which no longer handle computing load are either hibernated or switched off. Step S403 contains the steps S306 to S321 contained within the blue dotted box in Fig. 3. Once the delivery of cooling resources has been adjusted in step S403, the flow continues to step S404. When new VMs are started or running ones stopped, or once a predetermined number of new VMs are started or running ones stopped, the process is restarted from step S401; otherwise the process remains at step S404.

The cooling resource supply management process that has been described in this document and in particular as set out in Figure 6 can be used in a simulation to determine energy efficient spatial distribution of computing load and energy efficient settings for air handling entities 200. In such a procedure, the computing environment is a simulation program and the computing entities and air handling entities are elements of the simulation program. The geometry of the enclosure of the simulation program may be representative of a corresponding physical computing environment, so that settings and spatial distributions established by the procedure set out in Figure 7 can be used to control the corresponding physical computing environment.

As shown in Figure 7, the flow starts at step S500 with a pre-existing spatial VM distribution. The pre existing spatial VM distribution in the simulation program may be representative of the spatial VM distribution in the corresponding physical computing environment at the time of operation of the simulation program. At step S501 a target cooling region from among the plurality of cooling regions 310 is selected, and the procedure S502, which is steps S401 to S403 of Figure 6, is executed with the target cooling region as the destination to which computing load is migrated. The energy consumption of each resulting combination of VM placement and cooling system adjustment is stored at step S503. Step S504 checks whether all cooling regions have been the target cooling region, and if not the flow returns to step S501 and a new target cooling region is selected. If all cooling regions have been the target cooling region, then the target cooling region which gave rise to the lowest power consumption is retrieved and at step S505 the spatial VM distribution and settings for air handling entities that were determined with that cooling region as the target cooling region are implemented in the corresponding physical computing environment, and the flow proceeds to step S506. In this way, all possible combinations of VM placement and air handling entity settings can be explored in the simulation program to find the one that attains minimum energy consumption before changing settings in the corresponding physical environment. If new VMs are being started or running ones are being stopped at step S506 the procedure is re-started from step S501; if this is not the case, the process remains in step S506. Given the time, storage and bandwidths costs associated to VM migration, the procedure that has been described in the preceding paragraph and in Figure 7 is especially suited for incorporation into an optimisation tool prior to the implementation of actual changes in the data centre.

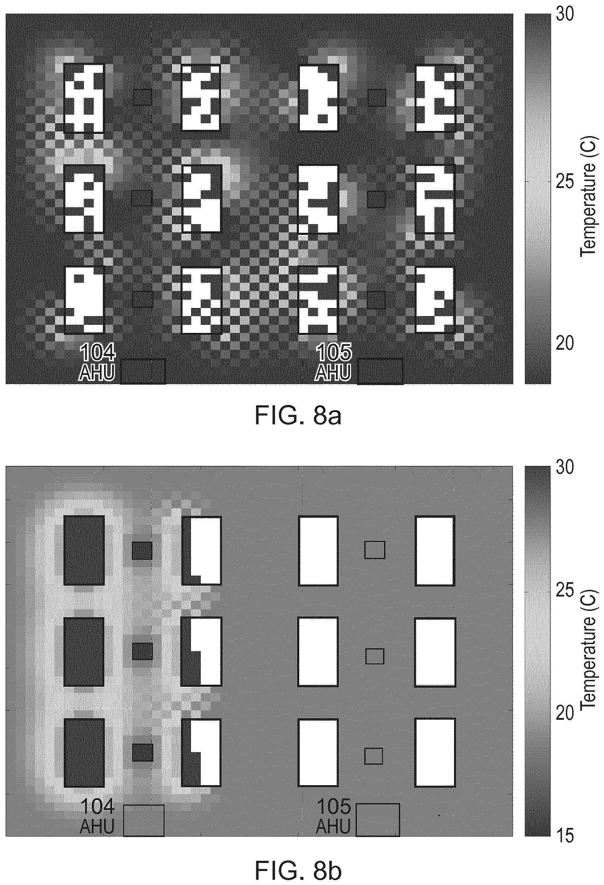

Figure 8a shows a simplified representation of the temperature distribution corresponding to the exemplary computing environment of Figure 3. In the scenario illustrated in Figure 8a it is assumed that the active servers are operating at a temperature of 30°C and that both AHUs 200 are active and supplying air to the enclosure at a temperature of 18.8°C. The heat profile of Figure 8a indicates that the air handling units 104 and 105 are relatively cool, as is the data centre floor, when compared with the active servers, which are relatively hot. Regions adjacent to the active servers are relatively hot in comparison to the air handling units and the rest of the data centre floor, and relatively cool in comparison to the active servers.

Figure 8b shows the temperature distribution for the exemplary computing environment of Figure 3 after the cooling resource supply management process of Figure 3 has been performed. The temperature of the air supplied by the left hand air handling unit has been set to 15°C, while the right hand AHU has been switched off. Figure 8b illustrates the principle of operation of embodiments, particularly when used in collaboration with load migration techniques which concentrate load in a particular cooling region or cooling regions. The heat profile of Figure 8b shows that the heat is concentrated at one side of the data centre floor. The active servers are relatively hot, and are all housed in racks at the left hand side of the Figure. The air handling units 104 and 105 are relatively cool, as is the data centre floor, when compared with the active servers, which are relatively hot. Regions adjacent to the active servers are relatively hot in comparison to the air handling units and the rest of the data centre floor, and relatively cool in comparison to the active servers. There are no hot regions at the right hand side of the data centre.

Purely by way of example, an estimate of the energy savings that can be achieved with embodiments can be obtained as follows: we will assume that the power consumed by an individual server ranges between 75 W at zero load and 250 W at 100% load; these figures are consistent with the data for some of the servers described in the SPECpower_ssj2008i benchmark. There are 256 servers distributed in 8 racks in the exemplary data centre shown in Figure 3, representing a maximum heat load of 64 kW. 129 of these servers contain VMs and are therefore running at 100% utilisation while the other 127 are idling, so the actual IT power consumption is 41.78 kW. Since the maximum heat load is 64 kW each AHU 200 should be able to remove 32 kW from the data centre hall 300 (a commercially available AHU with such a capacity consumes about 6 kW). These figures do not include the power required to run the other elements of the cooling system that are associated with a particular AHU such as pumps and chiller. The maximum possible power consumption of this exemplary data centre is then 76 kW. By turning off one of the AHUs, as well as switching off all idling servers, this figure can be brought down to 38 kW, a figure representing a 40% reduction in energy consumption.

## Claims

1. A controller (100) for a computing environment, the computing environment including:
a plurality of computing entities (400) housed within an enclosure (300), each computing entity (400) having a predetermined maximum operating temperature, the enclosure (300) comprising a plurality of cooling regions (310) each having a portion of the plurality of computing entities (400) located therein; and
a cooling system comprising a plurality of air handling entities (200), each cooling region (310) being assigned one of the air handling entities (200), each air handling entity (200) being in fluid communication with the cooling region (310) to which the air handling entity (200) is assigned;
the controller (100) comprising:
a load management module (102) configured to maintain an indication of which of the plurality of cooling regions (310) are in a first state and which of the plurality of cooling regions (310) are in a second state, the first state being handling less than a first predetermined threshold level of computing load and the second state being handling more than a second predetermined threshold level of computing load;
a load migration instructing module (104) configured to, when the load management module (102) indicates that one or more cooling regions (310) are in the second state, instruct a migration of load among the cooling regions (310), the instructed migration causing the level of computing load handled at one of the one or more cooling regions (310) indicated as being in the second state to enter the first state;
a temperature monitoring module (106) configured to monitor the operating temperature of each of the computing entities (400) and to indicate whether or not a cooling condition is satisfied, the cooling condition being that the operating temperature of the or each of a predetermined minimum number of computing entities (400) from among the plurality of computing entities (400) is above the respective maximum operating temperature; and
a cooling resource management module (108) being configured to perform a cooling resource supply management process comprising:
following execution of the instructed migration of load among the cooling regions (310), obtaining, as a first indication, an indication of whether or not the cooling condition is satisfied, and if the first indication is that that the cooling condition is not satisfied, reducing a first cooling resource supply rate, the first cooling resource supply rate being the rate at which cooling resources are delivered to the enclosure (300) by the or each air handling entity (200) assigned to a cooling region (310) in the first state from among the plurality of cooling regions (310).

2. The controller (100) according to claim 1, wherein the cooling resource supply management process further comprises:
if the first indication is that the cooling condition is satisfied, the cooling resource management module (108) is configured to increase a second cooling resource supply rate, the second cooling resource supply rate being the rate at which cooling resources are delivered to the enclosure (300) by the or each air handling entity (200) assigned to a cooling region (310) in the second state from among the plurality of cooling regions (310).

3. The controller (100) according to claim 2, wherein increasing the second cooling resource supply rate comprises incrementally increasing the second cooling resource supply rate and after each incremental increase, obtaining, as a second indication, a new indication of whether or not the cooling condition is satisfied from the temperature monitoring module (106), and repeating the incremental increasing and obtaining until either:
the second cooling resource supply rate reaches a predetermined maximum; or
the second indication is that the cooling condition is not satisfied.

4. The controller (100) according to claim 3, wherein:
if the second cooling resource supply rate reaches the predetermined maximum, then
the cooling resource supply management process further comprises increasing the first cooling resource supply rate.

5. The controller (100) according to claim 4, wherein increasing the first cooling resource supply rate comprises incrementally increasing the first cooling resource supply rate and after each incremental increase, obtaining, as a third indication, a new indication of whether or not the cooling condition is satisfied from the temperature monitoring module (106), and repeating the incremental increasing and obtaining until either:
the first cooling resource supply rate reaches a predetermined maximum; or
the third indication is that that the cooling condition is not satisfied.

6. The controller (100) according to any of claims 3 to 5, wherein:
if the second indication is that the cooling condition is not satisfied, then
the cooling resource supply management process further comprises decreasing the first cooling resource supply rate, wherein:
decreasing the first cooling resource supply rate comprises incrementally decreasing the first cooling resource supply rate and after each incremental decrease, obtaining, as a fourth indication, a new indication of whether or not the cooling condition is satisfied from the temperature monitoring module (106), and repeating the incremental decreasing and obtaining until either:
the first cooling resource supply rate reaches a predetermined minimum; or
the first indication is that the cooling condition is satisfied, whereupon the most recent incremental decrease of the first cooling resource supply rate is reversed.

7. The controller (100) according to claim 1, wherein reducing the first cooling resource supply rate comprises incrementally decreasing the first cooling resource supply rate and after each incremental decrease, obtaining, as a fifth indication, a new indication of whether or not the cooling condition is satisfied from the temperature monitoring module (106), and repeating the incremental decreasing and obtaining until either:
the first cooling resource supply rate reaches a predetermined minimum; or
the fifth indication that the cooling condition is satisfied, whereupon the most recent incremental decrease of the first cooling resource supply rate is reversed.

8. The controller (100) according to claim 7, wherein the cooling resource supply management process further comprises reducing the second cooling resource supply rate, wherein reducing the second cooling resource supply rate comprises incrementally decreasing the second cooling resource supply rate and after each incremental decrease, obtaining, as a sixth indication, an indication of whether or not the cooling condition is satisfied from the temperature monitoring module (106), and repeating the incremental decreasing and obtaining until either:
the second cooling resource supply rate reaches a predetermined minimum; or
the sixth indication is that the cooling condition is satisfied, whereupon the most recent incremental decrease of the second cooling resource supply rate is reversed.

9. The controller (100) according to any of claims 3, 5, 7, and 8, wherein
the repeatedly incrementally decreasing and obtaining or the repeatedly incrementally increasing and obtaining includes waiting for a predetermined delay period between the incremental increasing or the incremental decreasing and the obtaining.

10. The controller (100) according to any of claims 1 to 9, further comprising:
a storage module configured to store a cooling region population record identifying the cooling region (310) in which each of the plurality of computing entities (400) is located; wherein
the load migration instruction module is configured to refer to the cooling region population record in order to determine the level of computing load being handled in each of the plurality of cooling regions (310).

11. The controller (100) according to any of claims 1 to 10, wherein the load migration instruction module is configured to obtain an indication of the air inlet temperature at each of the computing entities (400) or at a rack housing each of the computing entities (400), and to instruct the redistribution of load from a first group of computing entities (400) to a second group of computing entities (400), the air inlet temperature of the first group of computing entities (400) or at the racks housing the first group of computing entities (400) being higher than the corresponding air inlet temperature of the second group.

12. The controller (100) according to any of claims 1 to 11, wherein, when a redistribution of computing load is instructed by the load migration instruction module, the computing entities (400) are configured to collectively execute a load migration algorithm in which computing load is iteratively migrated in a particular spatial direction or to one or more specified cooling regions (310).

13. The controller (100) according to any of the preceding claims, wherein the computing environment is a simulation program configured to simulate fluid flow in the enclosure (300), operating temperature of the computing entities (400), and energy consumption rate of the air handling entities (200); wherein
when a redistribution of computing load is instructed by the load migration instruction module, the computing entities (400) are configured to collectively execute a load migration algorithm in which computing load is iteratively migrated to a migration target, the migration target being one or more specified cooling regions (310) from among the cooling regions (310), the load migration instruction module being configured to iterate through a plurality of different migration targets, and following the execution of the migration instructed for each migration target, the cooling resource management module (108) is configured to perform the cooling resource supply management process defined by claims 1 to 9, and, for each migration target, to maintain a record of the energy consumption rate of the air handling entities (200) at the end of the cooling resource supply management process.

14. A control method for a computing environment, the computing environment including:
a plurality of computing entities (400) housed within an enclosure (300), each computing entity (400) having a predetermined maximum operating temperature, the enclosure (300) comprising a plurality of cooling regions (310) each having a portion of the plurality of computing entities (400) located therein; and
a cooling system comprising a plurality of air handling entities (200), each cooling region (310) being assigned an air handling entity (200), each air handling entity (200) being in fluid communication with the cooling region (310) to which the air handling entity (200) is assigned;
the method comprising:
maintaining an indication of which of the plurality of cooling regions (310) are in a first state and which of the plurality of cooling regions (310) are in a second state, the first state being handling less than a predetermined threshold level of computing load and the second state being handling more than the predetermined threshold level of computing load;
when the indication is that one or more cooling regions (310) are in the second state, instructing a migration of load among the cooling regions (310), the instructed migration causing the level of computing load handled at one of the one or more cooling regions (310) in the second state to enter the first state;
monitoring the operating temperature of each of the computing entities (400) and indicating whether or not a cooling condition is satisfied, the cooling condition being that the operating temperature of the or each of a predetermined minimum number of computing entities (400) from among the plurality of computing entities (400) is above the respective maximum operating temperature; and
performing a cooling resource supply management process comprising:
following execution of the instructed migration of load among the cooling regions (310), obtaining, as a first indication, and indication of whether or not the cooling condition is satisfied, and if the first indication is that that the cooling condition is not satisfied, reducing a first cooling resource supply rate, the first cooling resource supply rate being the rate at which cooling resources are delivered to the enclosure (300) by the or each air handling entity (200) assigned to a cooling region (310) in the first state from among the plurality of cooling regions (310).

15. A system comprising a plurality of computing entities (400) housed within an enclosure (300), each computing entity (400) having a predetermined maximum operating temperature, the enclosure (300) comprising a plurality of cooling regions (310) each having a portion of the plurality of computing entities (400) located therein;
a cooling system comprising a plurality of air handling entities (200), each cooling region (310) being assigned an air handling entity (200), each air handling entity (200) being in fluid communication with the cooling region (310) to which the air handling entity (200) is assigned; and
a controller (100) according to any of claims 1 to 14.

16. A computer program which, when executed by a computing device, causes the computing device to function as the controller (100) of claims 1 to 13 or to execute the control method of claim 14.

## Patentansprüche

1. Steuereinheit (100) für eine Datenverarbeitungsumgebung, wobei die Datenverarbeitungsumgebung Folgendes beinhaltet:
mehrere Datenverarbeitungsentitäten (400), die in einem Gehäuse (300) untergebracht sind, wobei jede Datenverarbeitungsentität (400) eine vorherbestimmte maximale Betriebstemperatur aufweist, wobei das Gehäuse (300) mehrere Kühlregionen (310) umfasst, die jeweils einen Teil der mehreren Datenverarbeitungsentitäten (400) darin angeordnet aufweisen; und
ein Kühlsystem, das mehrere Lufthandhabungsentitäten (200) umfasst, wobei jede Kühlregion (310) einer der Lufthandhabungsentitäten (200) zugeordnet ist, wobei jede Lufthandhabungsentität (200) in Fluidkommunikation mit der Kühlregion (310), der die Lufthandhabungsentität (200) zugeordnet ist, steht;
wobei die Steuereinheit (100) Folgendes umfasst:
ein Lastmanagementmodul (102), das dazu konfiguriert ist, eine Angabe dazu, welche der mehreren Kühlregionen (310) in einem ersten Zustand sind und welche der mehreren Kühlregionen (310) in einem zweiten Zustand sind, zu pflegen, wobei der erste Zustand das Handhaben von weniger als einem ersten vorherbestimmten Schwellenwert der Datenverarbeitungslast ist und der zweite Zustand das Handhaben von mehr als einem zweiten vorherbestimmten Schwellenwert der Datenverarbeitungslast ist;
ein Lastmigrationsanweisungsmodul (104), das dazu konfiguriert ist, wenn das Lastmanagementmodul (102) angibt, dass eine oder mehrere Kühlregionen (310) in dem zweiten Zustand sind, eine Migration der Last unter den Kühlregionen (310) anzuweisen, wobei die angewiesene Migration bewirkt, dass der Umfang der Datenverarbeitungslast, der an einer der einen oder der mehreren Kühlregionen (310), die als in dem zweiten Zustand seiend angegeben werden, gehandhabt wird, in den ersten Zustand eintritt;
ein Temperaturüberwachungsmodul (106), das dazu konfiguriert ist, die Betriebstemperatur von jeder der Datenverarbeitungsentitäten (400) zu überwachen und anzugeben, ob eine Kühlbedingung erfüllt wird oder nicht, wobei die Kühlbedingung ist, dass die Betriebstemperatur der oder jeder einer vorherbestimmten Mindestanzahl der Datenverarbeitungsentitäten (400) aus den mehreren Datenverarbeitungsentitäten (400) oberhalb der jeweiligen maximalen Betriebstemperatur ist; und
ein Kühlressourcenmanagementmodul (108), das dazu konfiguriert ist, einen Kühlressourcenzufuhrmanagementvorgang durchzuführen, der Folgendes umfasst:
nach Ausführung der angewiesenen Migration der Last unter den Kühlregionen (310) Erhalten einer Angabe als eine erste Angabe, ob die Kühlbedingung erfüllt wird oder nicht, und wenn die erste Angabe ist, dass die Kühlbedingung nicht erfüllt wird, Senken einer ersten Kühlressourcenzufuhrrate, wobei die erste Kühlressourcenzufuhrrate die Rate ist, bei der Kühlressourcen zu dem Gehäuse (300) durch die oder jede Lufthandhabungsentität (200), die einer Kühlregion (310) in dem ersten Zustand aus den mehreren Kühlregionen (310) zugeordnet ist, geliefert werden.

2. Steuereinheit (100) nach Anspruch 1, wobei der Kühlressourcenzufuhrmanagementvorgang weiterhin Folgendes umfasst:
wenn die erste Angabe ist, dass die Kühlbedingung erfüllt wird, das Kühlressourcenmanagementmodul (108) dazu konfiguriert ist, eine zweite Kühlressourcenzufuhrrate zu erhöhen, wobei die zweite Kühlressourcenzufuhrrate die Rate ist, bei der Kühlressourcen zu dem Gehäuse (300) durch die oder jede Lufthandhabungsentität (200), die einer Kühlregion (310) in dem zweiten Zustand aus den mehreren Kühlregionen (310) zugeordnet ist, geliefert werden.

3. Steuereinheit (100) nach Anspruch 2, wobei das Erhöhen der zweiten Kühlressourcenzufuhrrate das inkrementelle Erhöhen der zweiten Kühlressourcenzufuhrrate und nach jeder inkrementellen Erhöhung das Erhalten einer neuen Angabe als eine zweite Angabe, ob die Kühlbedingung erfüllt wird oder nicht, von dem Temperaturüberwachungsmodul (106) und das Wiederholen des inkrementellen Erhöhens und des Erhaltens umfasst, bis entweder:
die zweite Kühlressourcenzufuhrrate ein vorherbestimmtes Maximum erreicht oder
die zweite Angabe ist, dass die Kühlbedingung nicht erfüllt wird.

4. Steuereinheit (100) nach Anspruch 3, wobei:
wenn die zweite Kühlressourcenzufuhrrate das vorherbestimmte Maximum erreicht,
der Kühlressourcenzufuhrmanagementvorgang dann weiterhin das Erhöhen der ersten Kühlressourcenzufuhrrate umfasst.

5. Steuereinheit (100) nach Anspruch 4, wobei das Erhöhen der ersten Kühlressourcenzufuhrrate das inkrementelle Erhöhen der ersten Kühlressourcenzufuhrrate und nach jeder inkrementellen Erhöhung das Erhalten einer neuen Angabe als eine dritte Angabe, ob die Kühlbedingung erfüllt wird oder nicht, von dem Temperaturüberwachungsmodul (106) und das Wiederholen des inkrementellen Erhöhens und des Erhaltens umfasst, bis entweder:
die erste Kühlressourcenzufuhrrate ein vorherbestimmtes Maximum erreicht oder
die dritte Angabe ist, dass die Kühlbedingung nicht erfüllt wird.

6. Steuereinheit (100) nach einem der Ansprüche 3 bis 5, wobei:
wenn die zweite Angabe ist, dass die Kühlbedingung nicht erfüllt wird,
der Kühlressourcenzufuhrmanagementvorgang dann weiterhin das Senken der ersten Kühlressourcenzufuhrrate umfasst, wobei:
das Senken der ersten Kühlressourcenzufuhrrate das inkrementelle Senken der ersten Kühlressourcenzufuhrrate und nach jeder inkrementellen Senkung das Erhalten einer neuen Angabe als eine vierte Angabe, ob die Kühlbedingung erfüllt wird oder nicht, von dem Temperaturüberwachungsmodul (106) und das Wiederholen des inkrementellen Senkens und des Erhaltens umfasst, bis entweder:
die erste Kühlressourcenzufuhrrate ein vorherbestimmtes Minimum erreicht oder
die erste Angabe ist, dass die Kühlbedingung erfüllt wird, woraufhin die letzte inkrementelle Senkung der ersten Kühlressourcenzufuhrrate rückgängig gemacht wird.

7. Steuereinheit (100) nach Anspruch 1, wobei das Senken der ersten Kühlressourcenzufuhrrate das inkrementelle Senken der ersten Kühlressourcenzufuhrrate und nach jeder inkrementellen Senkung das Erhalten einer neuen Angabe als eine fünfte Angabe, ob die Kühlbedingung erfüllt wird oder nicht, von dem Temperaturüberwachungsmodul (106) und das Wiederholen des inkrementellen Senkens und des Erhaltens umfasst, bis entweder:
die erste Kühlressourcenzufuhrrate ein vorherbestimmtes Minimum erreicht oder
die fünfte Angabe ist, dass die Kühlbedingung erfüllt wird, woraufhin die letzte inkrementelle Senkung der ersten Kühlressourcenzufuhrrate rückgängig gemacht wird.

8. Steuereinheit (100) nach Anspruch 7, wobei der der Kühlressourcenzufuhrmanagementvorgang weiterhin das Senken der zweiten Kühlressourcenzufuhrrate umfasst, wobei das Senken der zweiten Kühlressourcenzufuhrrate das inkrementelle Senken der zweiten Kühlressourcenzufuhrrate und nach jeder inkrementellen Senkung das Erhalten einer Angabe als eine sechste Angabe, ob die Kühlbedingung erfüllt wird oder nicht, von dem Temperaturüberwachungsmodul (106) und das Wiederholen des inkrementellen Senkens und des Erhaltens umfasst, bis entweder:
die zweite Kühlressourcenzufuhrrate ein vorherbestimmtes Minimum erreicht oder
die sechste Angabe ist, dass die Kühlbedingung erfüllt wird, woraufhin die letzte inkrementelle Senkung der zweiten Kühlressourcenzufuhrrate rückgängig gemacht wird.

9. Steuereinheit (100) nach einem der Ansprüche 3, 5, 7 und 8, wobei
das wiederholte inkrementelle Senken und Erhalten oder das wiederholte Erhöhen oder Erhalten das Warten für eine vorherbestimmte Verzögerungszeit zwischen dem inkrementellen Erhöhen oder dem inkrementellen Senken und dem Erhalten beinhaltet.

10. Steuereinheit (100) nach einem der Ansprüche 1 bis 9, das weiterhin Folgendes umfasst:
ein Speichermodul, das dazu konfiguriert ist, einen Kühlregionspopulationsdatensatz zu speichern, der die Kühlregion (310) identifiziert, in der jede der mehreren Kühlentitäten (400) angeordnet ist; wobei
das Lastmigrationsanweisungsmodul dazu konfiguriert ist, sich auf den Kühlregionspopulationsdatensatz zu beziehen, um den Umfang der Datenverarbeitungslast zu bestimmen, der in jeder der mehreren Kühlregionen (310) gehandhabt wird.

11. Steuereinheit (100) nach einem der Ansprüche 1 bis 10, wobei das
Lastmigrationsanweisungsmodul dazu konfiguriert ist, eine Angabe der Lufteintrittstemperatur an jeder der Datenverarbeitungsentitäten (400) an einem Rack, das jede der Datenverarbeitungsentitäten unterbringt, zu erhalten und die Neuverteilung der Last von einer ersten Gruppe von Datenverarbeitungsentitäten (400) zu einer zweiten Gruppe von Datenverarbeitungsentitäten (400) anzuweisen, wobei die Lufteintrittstemperatur der ersten Gruppe von Datenverarbeitungsentitäten (400) oder der Racks, die die erste Gruppe von Datenverarbeitungsentitäten (400) unterbringen, höher als die entsprechende Lufteintrittstemperatur der zweiten Gruppe ist.

12. Steuereinheit (100) nach einem der Ansprüche 1 bis 11, wobei, wenn eine Neuverteilung der Datenverarbeitungslast von dem Lastmigrationsanweisungsmodul angewiesen wird, die Datenverarbeitungsentitäten (400) dazu konfiguriert sind, gemeinsam einen Lastmigrationsalgorithmus auszuführen, in dem die Datenverarbeitungslast iterativ in einer besonderen Raumrichtung oder zu einer oder mehreren spezifizierten Kühlregionen (310) migriert wird.

13. Steuereinheit (100) nach einem der vorhergehenden Ansprüche, wobei die Datenverarbeitungsumgebung ein Simulationsprogramm ist, das dazu konfiguriert ist, eine Fluidströmung in dem Gehäuse (300), eine Betriebstemperatur der Datenverarbeitungsentitäten (400) und eine Energieverbrauchsrate der Lufthandhabungsentitäten (200) zu simulieren; wobei,
wenn eine Neuverteilung der Datenverarbeitungslast von dem Lastmigrationsanweisungsmodul angewiesen wird, die Datenverarbeitungsentitäten (400) dazu konfiguriert sind, gemeinsam einen Lastmigrationsalgorithmus auszuführen, in dem die Datenverarbeitungslast iterativ zu einem Migrationsziel migriert wird, wobei es sich bei dem Migrationsziel um eine oder mehrere spezifizierte Kühlregionen (310) aus den Kühlregionen (310) handelt, wobei das Lastmigrationsanweisungsmodul dazu konfiguriert ist, durch mehrere unterschiedliche Migrationsziele zu iterieren, und nach der Ausführung der Migration, die für jedes Migrationsziel angewiesen wurde, das Kühlressourcenmanagementmodul (108) dazu konfiguriert ist, den von den Ansprüchen 1 bis 9 definierten Kühlressourcenmanagementvorgang durchzuführen und für jedes Migrationsziel einen Datensatz der Energieverbrauchsrate der Lufthandhabungsentitäten (200) zum Ende des Kühlressourcenzufuhrmanagementvorgangs zu pflegen.

14. Steuerverfahren für eine Datenverarbeitungsumgebung, wobei die Datenverarbeitungsumgebung Folgendes beinhaltet:
mehrere Datenverarbeitungsentitäten (400), die in einem Gehäuse (300) untergebracht sind, wobei jede Datenverarbeitungsentität (400) eine vorherbestimmte maximale Betriebstemperatur aufweist, wobei das Gehäuse (300) mehrere Kühlregionen (310) umfasst, die jeweils einen Teil der mehreren Datenverarbeitungsentitäten (400) darin angeordnet aufweisen; und
ein Kühlsystem, das mehrere Lufthandhabungsentitäten (200) umfasst, wobei jede Kühlregion (310) einer Lufthandhabungsentität (200) zugeordnet ist, wobei jede Lufthandhabungsentität (200) in Fluidkommunikation mit der Kühlregion (310), der die Lufthandhabungsentität (200) zugeordnet ist, steht;
wobei das Verfahren Folgendes umfasst:
Pflegen einer Angabe dazu, welche der mehreren Kühlregionen (310) in einem ersten Zustand sind und welche der mehreren Kühlregionen (310) in einem zweiten Zustand sind, wobei der erste Zustand das Handhaben von weniger als einem vorherbestimmten Schwellenwert der Datenverarbeitungslast ist und der zweite Zustand das Handhaben von mehr als dem vorherbestimmten Schwellenwert der Datenverarbeitungslast ist;
wenn die Angabe ist, dass eine oder mehrere Kühlregionen (310) in dem zweiten Zustand sind, Anweisen einer Migration der Last unter den Kühlregionen (310), wobei die angewiesene Migration bewirkt, dass der Umfang der Datenverarbeitungslast, der an einer der einen oder der mehreren Kühlregionen (310) in dem zweiten Zustand gehandhabt wird, in den ersten Zustand eintritt;
Überwachen der Betriebstemperatur von jeder der Datenverarbeitungsentitäten (400) und Angeben, ob eine Kühlbedingung erfüllt wird oder nicht, wobei die Kühlbedingung ist, dass die Betriebstemperatur der oder jeder einer vorherbestimmten Mindestanzahl der Datenverarbeitungsentitäten (400) aus den mehreren Datenverarbeitungsentitäten (400) oberhalb der jeweiligen maximalen Betriebstemperatur ist; und
Durchführen eines Kühlressourcenzufuhrmanagementvorgangs, der Folgendes umfasst:
nach Ausführung der angewiesenen Migration der Last unter den Kühlregionen (310) Erhalten einer Angabe als eine erste Angabe, ob die Kühlbedingung erfüllt wird oder nicht, und wenn die erste Angabe ist, dass die Kühlbedingung nicht erfüllt wird, Senken einer ersten Kühlressourcenzufuhrrate, wobei die erste Kühlressourcenzufuhrrate die Rate ist, bei der Kühlressourcen zu dem Gehäuse (300) durch die oder jede Lufthandhabungsentität (200), die einer Kühlregion (310) in dem ersten Zustand aus den mehreren Kühlregionen (310) zugeordnet ist, geliefert werden.

15. System, das mehrere Datenverarbeitungsentitäten (400), die in einem Gehäuse (300) untergebracht sind, wobei jede Datenverarbeitungsentität (400) eine vorherbestimmte maximale Betriebstemperatur aufweist, wobei das Gehäuse (300) mehrere Kühlregionen (310) umfasst, die jeweils einen Teil der mehreren Datenverarbeitungsentitäten (400) darin angeordnet aufweisen;
ein Kühlsystem, das mehrere Lufthandhabungsentitäten (200) umfasst, wobei jede Kühlregion (310) einer Lufthandhabungsentität (200) zugeordnet ist, wobei jede Lufthandhabungsentität (200) in Fluidkommunikation mit der Kühlregion (310), der die Lufthandhabungsentität (200) zugeordnet ist, steht; und
eine Steuereinheit (100) nach einem der Ansprüche 1 bis 14 umfasst.

16. Computerprogramm, die bei Ausführung durch eine Datenverarbeitungsvorrichtung bewirkt, dass die Datenverarbeitungsvorrichtung als die Steuereinheit (100) nach den Ansprüchen 1 bis 13 fungiert oder das Steuerverfahren nach Anspruch 14 ausführt.

## Revendications

1. Dispositif de commande (100) pour un environnement informatique, l'environnement informatique comprenant :
une pluralité d'entités informatiques (400) logées dans une enceinte (300), chaque entité informatique (400) ayant une température de fonctionnement maximale prédéterminée, l'enceinte (300) comprenant une pluralité de régions de refroidissement (310) ayant chacune une partie de la pluralité d'entités informatiques (400) située à l'intérieur ; et
un système de refroidissement comprenant une pluralité d'entités de traitement d'air (200), chaque région de refroidissement (310) étant affectée à une des entités de traitement d'air (200), chaque entité de traitement d'air (200) étant en communication fluidique avec la région de refroidissement (310) à laquelle l'entité de traitement de l'air (200) est affectée ;
le dispositif de commande (100) comprenant :
un module de gestion de charge (102) configuré pour conserver une indication des régions de la pluralité de régions de refroidissement (310) qui sont dans un premier état et des régions de la pluralité de régions de refroidissement (310) qui sont dans un second état, le premier état étant un traitement inférieur à un premier niveau de seuil prédéterminé de charge informatique et le second état étant un traitement supérieur à un second niveau de seuil prédéterminé de charge informatique ;
un module d'instruction de migration de charge (104) configuré pour, lorsque le module de gestion de charge (102) indique qu'une ou plusieurs régions de refroidissement (310) sont dans le second état, ordonner une migration de charge parmi les régions de refroidissement (310), la migration ordonnée amenant le niveau de charge informatique traitée dans l'une des une ou plusieurs régions de refroidissement (310) indiquées comme étant dans le second état à entrer dans le premier état ;
un module de surveillance de température (106) configuré pour surveiller la température de fonctionnement de chacune des entités informatiques (400) et pour indiquer si une condition de refroidissement est satisfaite ou non, la condition de refroidissement étant que la température de fonctionnement de l'entité ou de chacune d'un nombre minimum prédéterminé d'entités informatiques (400) parmi la pluralité d'entités informatiques (400) est supérieure à la température de fonctionnement maximale respective ; et
un module de gestion de ressources de refroidissement (108) configuré pour effectuer un processus de gestion d'alimentation en ressources de refroidissement comprenant les étapes consistant à :
après l'exécution de la migration de charge ordonnée parmi les régions de refroidissement (310), obtenir, en tant que première indication, une indication du fait que la condition de refroidissement est satisfaite ou non, et si la première indication est que la condition de refroidissement n'est pas satisfaite, réduire un premier débit d'alimentation en ressources de refroidissement, le première débit d'alimentation en ressources de refroidissement étant le débit auquel les ressources de refroidissement sont délivrées dans l'enceinte (300) par l'entité ou chaque entité de traitement d'air (200) affectée à une région de refroidissement (310) dans le premier état parmi la pluralité de régions de refroidissement (310).

2. Dispositif de commande (100) selon la revendication 1, dans lequel le processus de gestion d'alimentation en ressources de refroidissement comprend en outre :
si la première indication est que la condition de refroidissement est satisfaite, le module de gestion de ressources de refroidissement (108) est configuré pour augmenter un second débit d'alimentation en ressources de refroidissement, le second débit d'alimentation en ressources de refroidissement étant le débit auquel les ressources de refroidissement sont délivrées dans l'enceinte (300) par l'entité ou chaque entité de traitement d'air (200) affectée à une région de refroidissement (310) dans le second état parmi la pluralité de régions de refroidissement (310).

3. Dispositif de commande (100) selon la revendication 2, dans lequel l'augmentation du second débit d'alimentation en ressources de refroidissement comprend l'augmentation incrémentielle du second débit d'alimentation en ressources de refroidissement et après chaque augmentation incrémentielle, l'obtention, en tant que deuxième indication, d'une nouvelle indication du fait que la condition de refroidissement est satisfaite ou non à partir du module de surveillance de la température (106), et la répétition de l'augmentation incrémentielle et de l'obtention jusqu'à ce que :
le second débit d'alimentation en ressources de refroidissement atteint un maximum prédéterminé ; ou
la deuxième indication est que la condition de refroidissement n'est pas satisfaite.

4. Dispositif de commande (100) selon la revendication 3, dans lequel :
si le second débit d'alimentation en ressources de refroidissement atteint le maximum prédéterminé, alors
le processus de gestion d'alimentation en ressources de refroidissement comprend en outre l'augmentation du premier débit d'alimentation en ressources de refroidissement.

5. Dispositif de commande (100) selon la revendication 4, dans lequel l'augmentation du premier débit d'alimentation en ressources de refroidissement comprend l'augmentation incrémentielle du premier débit d'alimentation en ressources de refroidissement et après chaque augmentation incrémentielle, l'obtention, en tant que troisième indication, d'une nouvelle indication du fait que la condition de refroidissement est satisfaite ou non à partir du module de surveillance de la température (106), et la répétition de l'augmentation incrémentielle et de l'obtention jusqu'à ce que :
le premier débit d'alimentation en ressources de refroidissement atteint un maximum prédéterminé ; ou
la troisième indication est que la condition de refroidissement n'est pas satisfaite.

6. Dispositif de commande (100) selon l'une quelconque des revendications 3 à 5, dans lequel :
si la deuxième indication est que la condition de refroidissement n'est pas satisfaite, alors
le processus de gestion d'alimentation en ressources de refroidissement comprend en outre la diminution du premier débit d'alimentation en ressources de refroidissement, dans lequel :
la diminution du premier débit d'alimentation en ressources de refroidissement comprend la diminution incrémentielle du premier débit d'alimentation en ressources de refroidissement et après chaque diminution incrémentielle, l'obtention, en tant que quatrième indication, d'une nouvelle indication du fait que la condition de refroidissement est satisfaite ou non à partir du module de surveillance de température (106), et la répétition de la diminution incrémentielle et de l'obtention jusqu'à ce que :
le premier débit d'alimentation en ressources de refroidissement atteint un minimum prédéterminé ; ou
la première indication est que la condition de refroidissement est satisfaite, après quoi la diminution incrémentielle la plus récente du premier débit d'alimentation en ressources de refroidissement est inversée.

7. Dispositif de commande (100) selon la revendication 1, dans lequel la réduction du premier débit d'alimentation en ressources de refroidissement comprend la diminution incrémentielle du premier débit d'alimentation en ressources de refroidissement et après chaque diminution incrémentielle, l'obtention, en tant que cinquième indication, d'une nouvelle indication du fait que la condition de refroidissement est satisfaite ou non à partir du module de surveillance de température (106), et la répétition de la diminution incrémentielle et de l'obtention jusqu'à ce que :
le premier débit d'alimentation en ressources de refroidissement atteint un minimum prédéterminé ; ou
la cinquième indication est que la condition de refroidissement est satisfaite, après quoi la diminution incrémentielle la plus récente du premier débit d'alimentation en ressources de refroidissement est inversée.

8. Dispositif de commande (100) selon la revendication 7, dans lequel le processus de gestion d'alimentation en ressources de refroidissement comprend en outre la réduction du second débit d'alimentation en ressources de refroidissement, dans lequel la réduction du second débit d'alimentation en ressources de refroidissement comprend la diminution incrémentielle du second débit d'alimentation en ressources de refroidissement et après chaque diminution incrémentielle, l'obtention, en tant que sixième indication, d'une indication du fait que la condition de refroidissement est satisfaite ou non à partir du module de surveillance de température (106), et la répétition de la diminution incrémentielle et de l'obtention jusqu'à ce que :
le second débit d'alimentation en ressources de refroidissement atteint un minimum prédéterminé ; ou
la sixième indication est que la condition de refroidissement est satisfaite, après quoi la diminution incrémentielle la plus récente du second débit d'alimentation en ressources de refroidissement est inversée.

9. Dispositif de commande (100) selon l'une quelconque des revendications 3, 5, 7 et 8, dans lequel
la diminution incrémentielle et l'obtention répétées ou l'augmentation incrémentielle et l'obtention répétées comprennent l'attente pendant une période de retard prédéterminée entre l'augmentation incrémentielle ou la diminution incrémentielle et l'obtention.

10. Dispositif de commande (100) selon l'une quelconque des revendications 1 à 9, comprenant en outre :
un module de stockage configuré pour stocker un enregistrement de population de région de refroidissement identifiant la région de refroidissement (310) dans laquelle se trouve chacune de la pluralité d'entités informatiques (400) ; dans lequel
le module d'instruction de migration de charge est configuré pour se référer à l'enregistrement de population de région de refroidissement afin de déterminer le niveau de charge informatique qui est traitée dans chacune de la pluralité de régions de refroidissement (310).

11. Dispositif de commande (100) selon l'une quelconque des revendications 1 à 10, dans lequel le module d'instruction de migration de charge est configuré pour obtenir une indication de la température d'entrée d'air au niveau de chacune des entités informatiques (400) ou au niveau d'un un rack logeant chacune des entités informatiques (400), et pour ordonner la redistribution de charge d'un premier groupe d'entités informatiques (400) vers un second groupe d'entités informatiques (400), la température d'entrée d'air du premier groupe d'entités informatiques (400) ou au niveau des racks logeant le premier groupe d'entités informatiques (400) étant supérieure à la température d'entrée d'air correspondante du second groupe.

12. Dispositif de commande (100) selon l'une quelconque des revendications 1 à 11, dans lequel, lorsqu'une redistribution de charge informatique est ordonnée par le module d'instruction de migration de charge, les entités informatiques (400) sont configurées pour exécuter collectivement un algorithme de migration de charge dans lequel une charge informatique est migrée de manière itérative dans une direction spatiale particulière ou vers une ou plusieurs régions de refroidissement spécifiées (310).

13. Dispositif de commande (100) selon l'une quelconque des revendications précédentes, dans lequel l'environnement informatique est un programme de simulation configuré pour simuler un écoulement de fluide dans l'enceinte (300), la température de fonctionnement des entités informatiques (400), et le taux de consommation en énergie des entités de traitement d'air (200) ; dans lequel
lorsqu'une redistribution de charge informatique est ordonnée par le module d'instruction de migration de charge, les entités informatiques (400) sont configurées pour exécuter collectivement un algorithme de migration de charge dans lequel une charge informatique est migrée de manière itérative vers une cible de migration, la cible de migration étant une ou plusieurs régions de refroidissement spécifiées (310) parmi les régions de refroidissement (310), le module d'instruction de migration de charge étant configuré pour réitérer pour une pluralité de cibles de migration différentes, et après l'exécution de la migration ordonnée pour chaque cible de migration, le module de gestion de ressources de refroidissement (108) est configuré pour effectuer le processus de gestion d'alimentation en ressources de refroidissement défini par les revendications 1 à 9, et, pour chaque cible de migration, pour conserver un enregistrement du taux de consommation en énergie des entités de traitement d'air (200) à la fin du processus de gestion d'alimentation en ressources de refroidissement.

14. Procédé de commande pour un environnement informatique, l'environnement informatique comprenant :
une pluralité d'entités informatiques (400) logées dans une enceinte (300), chaque entité informatique (400) ayant une température de fonctionnement maximale prédéterminée, l'enceinte (300) comprenant une pluralité de régions de refroidissement (310) ayant chacune une partie de la pluralité d'entités informatiques (400) située à l'intérieur ; et
un système de refroidissement comprenant une pluralité d'entités de traitement d'air (200), chaque région de refroidissement (310) étant affectée à une entité de traitement d'air (200), chaque entité de traitement d'air (200) étant en communication fluidique avec la région de refroidissement (310) à laquelle l'entité de traitement de l'air (200) est affectée ;
le procédé comprenant les étapes consistant à :
conserver une indication des régions de la pluralité de régions de refroidissement (310) qui sont dans un premier état et des régions de la pluralité de régions de refroidissement (310) qui sont dans un second état, le premier état étant un traitement inférieur à un niveau de seuil prédéterminé de charge informatique et le second état étant un traitement supérieur au niveau de seuil prédéterminé de charge informatique ;
lorsque l'indication est qu'une ou plusieurs régions de refroidissement (310) sont dans le second état, ordonner une migration de charge parmi les régions de refroidissement (310), la migration ordonnée amenant le niveau de charge informatique traitée dans une des une ou plusieurs régions de refroidissement (310) dans le second état à entrer dans le premier état ;
surveiller la température de fonctionnement de chacune des entités informatiques (400) et indiquer si une condition de refroidissement est satisfaite ou non, la condition de refroidissement étant que la température de fonctionnement de l'entité ou de chacune d'un nombre minimal prédéterminé d'entités informatiques (400) parmi la pluralité d'entités informatiques (400) est supérieure à la température de fonctionnement maximale respective ; et
effectuer un processus de gestion d'alimentation en ressources de refroidissement comprenant les étapes consistant à :
après l'exécution de la migration de charge ordonnée parmi les régions de refroidissement (310), obtenir, en tant que première indication, un indication du fait que la condition de refroidissement est satisfaite ou non, et si la première indication est que la condition de refroidissement n'est pas satisfaite, réduire un premier débit d'alimentation en ressources de refroidissement, le premier débit d'alimentation en ressources de refroidissement étant le débit auquel des ressources de refroidissement sont délivrées dans l'enceinte (300) par l'entité ou chaque entité de traitement d'air (200) affectée à une région de refroidissement (310) dans le premier état parmi la pluralité de régions de refroidissement (310).

15. Système comprenant une pluralité d'entités informatiques (400) logées dans une enceinte (300), chaque entité informatique (400) ayant une température de fonctionnement maximale prédéterminée, l'enceinte (300) comprenant une pluralité de régions de refroidissement (310) ayant chacune une partie de la pluralité d'entités informatiques (400) située à l'intérieur ;
un système de refroidissement comprenant une pluralité d'entités de traitement d'air (200), chaque région de refroidissement (310) étant affectée à une entité de traitement d'air (200), chaque entité de traitement d'air (200) étant en communication fluidique avec la région de refroidissement (310) à laquelle l'entité de traitement d'air (200) est affectée ; et
un dispositif de commande (100) selon l'une quelconque des revendications 1 à 14.

16. Programme informatique qui, lorsqu'il est exécuté par un dispositif informatique, amène le dispositif informatique à fonctionner comme dispositif de commande (100) selon les revendications 1 à 13 ou à exécuter le procédé de commande selon la revendication 14.
